(19) Europäisches Patentamt
European Patent Office
Office européen des brevets

(11) **EP 4 707 254 A1**

(12) **EUROPEAN PATENT APPLICATION**
published in accordance with Art. 153(4) EPC

(43) Date of publication:
**11.03.2026 Bulletin 2026/11**

(21) Application number: **25802946.1**

(22) Date of filing: **13.05.2025**

(51) International Patent Classification (IPC):
$C03C\ 10/04^{(2006.01)}$    $G03B\ 17/56^{(2021.01)}$
$G03B\ 11/04^{(2021.01)}$    $H05K\ 5/02^{(2006.01)}$
$H05K\ 5/03^{(2006.01)}$    $G09F\ 9/30^{(2006.01)}$
$C03C\ 10/12^{(2006.01)}$    $C03C\ 21/00^{(2006.01)}$

(86) International application number:
**PCT/CN2025/094618**

(87) International publication number:
**WO 2025/237299 (20.11.2025 Gazette 2025/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **13.05.2024 CN 202410590891**

(71) Applicant: **Chongqing Aureavia Hi-Tech Glass
Co., Ltd.
Chongqing 400714 (CN)**

(72) Inventor: **LONG, Chenhui
Chongqing 400714 (CN)**

(74) Representative: **Groth & Co. KB
P.O. Box 6107
102 32 Stockholm (SE)**

(54) **CHEMICALLY STRENGTHENED GLASS-CERAMIC, COVER GLASS, ELECTRONIC DEVICE AND GLASS COMPONENT**

(57) Provided in the present invention are a chemically strengthened microcrystalline glass, a cover glass, an electronic device, and a glass component, belonging to the technical field of microcrystalline glass. According to the present invention, by making the surface composition and stress structure of chemically strengthened microcrystalline glass with lithium disilicate as the main crystalline phase meet specific requirements, the chemically strengthened microcrystalline glass can achieve good weather resistance while maintaining a high stress level, thereby better ensuring that the chemically strengthened microcrystalline glass meets application demands.

FIG. 1

# EP 4 707 254 A1

**Description**

## CROSS-REFERENCE TO RELATED APPLICATION

The present invention claims priority to Chinese patent application No. 202410590891.4, entitled "CHEMICALLY STRENGTHENED MICROCRYSTALLINE GLASS, COVER GLASS, ELECTRONIC DEVICE, AND GLASS COMPONENT", filed with the China National Intellectual Property Administration on May 13, 2024, the entire contents of which are incorporated herein by reference.

## TECHNICAL FIELD

The present invention relates to the technical field of microcrystalline glass, specifically to a chemically strengthened microcrystalline glass, a cover glass, an electronic device, and a glass component.

## BACKGROUND ART

Microcrystalline glass is a kind of solid composite material formed by controlled crystallization of base glass during heat treatment. Microcrystalline glass consists of both microcrystalline phase and a glass phase. Compared to ordinary glass materials without microcrystalline phase, microcrystalline glass typically exhibits higher strength. This is because the microcrystalline phase has higher strength than the glass phase and absorbs more energy upon breaking. Moreover, the microcrystal phase can prolong the crack propagation path, thereby hindering crack propagation. As a result, microcrystalline glass can dissipate more impact energy in the process of breaking and crushing.

In recent years, microcrystalline glass has been increasingly used in various electronic devices, such as mobile phones, watches, tablets, laptops, e-readers, and similar devices, serving as cover glass for electronic devices, such as cover glass for display screen and cover glass for rear cover of electronic devices. For the display screen of electronic device, the cover glass is generally required to possess better optical properties, along with thinner thickness, higher mechanical performance, better environmental durability or weather resistance.

In order to further improve the mechanical performance of microcrystalline glass, chemical strengthening is typically applied to microcrystalline glass through ion exchange, producing chemically strengthened microcrystalline glass with a relatively high stress level, a relatively high mechanical strength performance, and a relatively high damage resistance performance.

For microcrystalline glass where the main crystalline phase is lithium disilicate, sodium-lithium ion exchange is mainly carried out during chemical strengthening, that is, during the chemical strengthening process, sodium ions in molten salt bath for chemical strengthening are ion-exchanged with lithium ions in microcrystalline glass. In order to obtain chemically strengthened microcrystalline glass with higher mechanical performance, it is usually necessary to exchange a certain amount of sodium ions into microcrystalline glass, so as to induce high stress level by utilizing the volume difference between exchanged ions, thus improving the mechanical strength performance. If the content of exchanged sodium ions is few, the improvement of mechanical strength performance cannot be realized.

It should be noted that this part of the present invention only provides background related to the present invention and does not necessarily constitute prior art or known technology.

## SUMMARY

For microcrystalline glass with lithium disilicate as the main crystalline phase, when sodium-lithium exchange is performed during chemical strengthening, while it can increase the deep compression stress and compressive stress layer depth of the microcrystalline glass, the resulting chemically strengthened microcrystalline glass tends to form a sodium-rich layer on its surface. When the exchange leads to increased sodium content on the surface of the chemically strengthened microcrystalline glass, although mechanical performance can be improved, the higher sodium content on the surface tends to reduce the environmental durability or weather resistance of the chemically strengthened microcrystalline glass. This typically manifests as, when the chemically strengthened microcrystalline glass with a relatively high sodium content on its surface is exposed to the sweat erosion environments for a long time or it continues to be used after exposure to humid conditions, the surface smoothness of the chemically strengthened microcrystalline glass tends to degrade, becoming rougher. More severely, the chemically strengthened microcrystalline glass can be hazed, forming unremovable spots or whitish traces on the surface. These conditions not only reduce the tactile experience for users when touching the screen but also significantly impair the display quality and appearance of the chemically strengthened microcrystalline glass due to the issues of hazing, whitening, and spots. Moreover, if the issues of spots, hazing, or whitening occur in the camera position, the imaging performance of the mobile phone can be severely affected.

The objective of the present invention is to provide a chemically strengthened microcrystalline glass that maintains high stress levels, ensures high mechanical strength performance, and exhibits good environmental durability or weather resistance by controlling the surface composition and stress of the chemically strengthened microcrystalline glass with lithium disilicate as the main crystalline phase to meet specific relationships.

In order to achieve the above objective, the following technical solutions are adopted in the present invention.

In a first aspect, a chemically strengthened microcrystalline glass is provided. The chemically strengthened microcrystalline glass contains a lithium disilicate crystalline phase, wherein the lithium disilicate crystalline phase has a larger mass percentage than other crystalline phases existing in the chemically strengthened microcrystalline glass. The chemically strengthened microcrystalline glass has a compression stress layer on the surface and a tensile stress layer inside. The chemically strengthened microcrystalline glass satisfies:

$N=n*(CT\_LD-50000)/10000$, $-32.5<N<15$, preferably, $-28.0 \leq N \leq 0$, and more preferably, $-20.0 \leq N \leq -2.5$, wherein $n=($mass percentage of $Na_2O$ on the surface of the chemically strengthened microcrystalline glass/mass percentage of $K_2O$ on the surface of the chemically strengthened microcrystalline glass$)^2$. The mass percentage of $Na_2O$ on the surface of the chemically strengthened microcrystalline glass and the mass percentage of $K_2O$ on the surface of the chemically strengthened microcrystalline glass are measured by XRF; CT\_LD represents the tensile stress line density, and the unit is MPa/mm. In Formula N, the data is substituted for calculation according to the above requirements of the units, and the calculated result is obtained without including the units themselves in the actual calculation.

In the present invention, by making the chemically strengthened microcrystalline glass meet the requirements of specific crystalline phase structure and the requirements of Formula N, the chemically strengthened microcrystalline glass maintains good weather resistance while under the condition of achieving high stress levels, thereby better guaranteeing that the chemically strengthened microcrystalline glass meets market application demands.

As an optional embodiment, the chemically strengthened microcrystalline glass satisfies: $45000\text{MPa/mm} \leq CT\_LD \leq 52000\text{MPa/mm}$, preferably, $45900\text{MPa/mm} \leq CT\_LD \leq 50000\text{MPa/mm}$, and more preferably, $47500\text{MPa/mm} \leq CT\_LD \leq 50000\text{MPa/mm}$.

By making the chemically strengthened microcrystalline glass meet the appropriate stress structure, it is beneficial to obtain chemically strengthened microcrystalline glass products with higher stress level, thereby facilitating the improvement of mechanical strength performance through the stress structure, so as to ensure that the chemically strengthened microcrystalline glass has excellent damage resistance performance.

As an optional embodiment, the value of Formula N is -2.52, -4.07, -4.47, -4.75, -10.59, -11.90, or -12.73; and/or the value of CT\_LD is 47517.24 MPa/mm, 48185.39 MPa/mm, 49692.43 MPa/mm, 47636.26 MPa/mm, 47919.69 MPa/mm, 47679.19 MPa/mm, or 48097.14 MPa/mm.

As an optional embodiment, as measured by XRF and calculated in terms of oxide mass percentage, the mass percentage of $Na_2O$ on the surface of the chemically strengthened microcrystalline glass is 5%-8.5%, preferably, 5.5%-7.5%; and/or,

as measured by XRF and calculated in terms of oxide mass percentage, the mass percentage of $K_2O$ on the surface of the chemically strengthened microcrystalline glass is 0.7%-2.0%, preferably, 0.7%-1.5%; and/or,
in terms of oxide mass percentage, in the composition at the center of the chemically strengthened microcrystalline glass or the composition of the tensile stress layer, the mass percentage of $Na_2O$ is 3%-3.5%, preferably, the mass percentage of $Na_2O$ is 3.1%-3.2%.

As an optional embodiment, as measured by XRF and calculated in terms of oxide mass percentage, the mass percentage of $Na_2O$ on the surface of the chemically strengthened microcrystalline glass is 5.30%, 6.12%, 7.00%, 5.21%, 6.32%, 5.17%, or 6.36%; and/or,

as measured by XRF and calculated in terms of oxide mass percentage, the mass percentage of $K_2O$ on the surface of the chemically strengthened microcrystalline glass is 1.25%, 0.81%, 0.77%, 1.24%, 0.80%, or 1.26%; and/or,
in terms of oxide mass percentage, in the composition at the center of the chemically strengthened microcrystalline glass or the composition of the tensile stress layer, the mass percentage of $Na_2O$ is 3.16% or 3.14%.

As an optional embodiment, the chemically strengthened microcrystalline glass satisfies:

$Y=\Delta C \times ((CT\_LD-50000)/100)^2$, $Y<60$, preferably, $Y \leq 50$, and more preferably, $Y \leq 20$, wherein $\Delta C$ represents the difference between the mass percentage of $Na_2O$ on the surface of the chemically strengthened microcrystalline glass and the mass percentage of $Na_2O$ at the center of the chemically strengthened microcrystalline glass, with the mass percentage of $Na_2O$ on the surface of the chemically strengthened microcrystalline glass being measured by XRF; CT_LD represents the tensile stress line density, and the unit is MPa/mm. In Formula Y, the data is substituted for calculation according to the above requirements of the units, and the calculated result is obtained without including the units themselves in the actual calculation.

By ensuring the chemically strengthened microcrystalline glass satisfies specific crystalline phase structures and meets the requirements of Formula Y, it facilitates achieving high stress levels in the chemically strengthened microcrystalline glass.

As an optional embodiment, the value of Formula Y is 0.36, 10.14, 11.58, 11.88, 13.02, 13.25, or 14.84.

As an optional embodiment, the chemically strengthened microcrystalline glass satisfies:

75MPa≤|CT_AV|≤120MPa, preferably, 77MPa≤|CT_AV|≤90MPa, where |CT_AV| represents the absolute value of the average tensile stress; and/or,
DOL_0 is 0.18t-0.25t, preferably, 0.20t-0.25t, where DOL_0 represents the depth of the compression stress layer, and t represents the thickness of the chemically strengthened microcrystalline glass; and/or
CS_50 is 150MPa-250MPa, preferably, 160 MPa-180 MPa, wherein CS_50 refers to the compressive stress value at the depth of 50μm from the main surface of chemically strengthened microcrystalline glass.

By making the chemically strengthened microcrystalline glass meet the appropriate stress structure, it is beneficial to obtain chemically strengthened microcrystalline glass products with a higher stress level, thereby facilitating the improvement of mechanical strength performance through the stress structure, so as to ensure that the chemically strengthened microcrystalline glass has excellent damage resistance performance.

As an optional embodiment, in terms of oxide molar percentage, the composition at the center of the chemically strengthened microcrystalline glass or the composition of the tensile stress layer includes: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.80%-3.20%, $B_2O_3$: 0-1.00%, and $Li_2O$: 25.32%-26.52%.

By satisfying the specific glass composition, it is beneficial to obtain microcrystalline glass satisfying the specific crystalline phase structure and chemically strengthened microcrystalline glass satisfying the specific stress structure.

As an optional embodiment, in terms of oxide molar percentage, the composition at the center of the chemically strengthened microcrystalline glass or the composition of the tensile stress layer includes:

the mole percentage of $SiO_2$ is 61.50%-63.30%, preferably, the mole percentage of $SiO_2$ is 62.00%-62.60%; and/or,
the mole percentage of $P_2O_5$ is 1.20%-1.91%, preferably, the mole percentage of $P_2O_5$ is 1.30%-1.60%; and/or,
the mole percentage of $Na_2O$ is 1.85%-3.05%, preferably, the mole percentage of $Na_2O$ is 2.20%-3.00%; and/or,
the mole percentage of $B_2O_3$ is 0-0.65%; and/or, the mole percentage of $ZrO_2$ is 4.20%-4.60%; and/or,
the mole percentage of $Li_2O$ is 25.52%-26.52%, preferably, the mole percentage of $Li_2O$ is 25.52%-26.00%.

As an optional embodiment, in terms of oxide molar percentage, the composition at the center of the chemically strengthened microcrystalline glass or the composition of the tensile stress layer includes:

the mole percentage of $SiO_2$ is 63.26%, 62.35%, or 62.52%; and/or,
the mole percentage of $Al_2O_3$ is 2.87%, 2.94%, or 2.92%; and/or,
the mole percentage of $P_2O_5$ is 1.41% or 1.53%; and/or,
the mole percentage of $ZrO_2$ is 4.33% or 4.34%; and/or,
the mole percentage of $Na_2O$ is 2.36%, 2.93% or 2.96%; and/or,
the mole percentage of $Li_2O$ is 25.77%, 25.91%or 25.73%.

As an optional embodiment, in the composition at the center of the chemically strengthened microcrystalline glass or the composition of the tensile stress layer, the mole percentage of $Na_2O$ [$Na_2O$], the mole percentage of $B_2O_3$ [$B_2O_3$] and the mole percentage of $ZrO_2$ [$ZrO_2$] satisfy the following relationship:

$Z=-1.344×(2.65-100×[Na_2O])^2+0.466×100×[B_2O_3]+1.203×100×[ZrO_2]$, 4.80≤Z≤5.35, preferably, 5.05≤Z≤5.25; and/or
in the composition at the center of the chemically strengthened microcrystalline glass or the composition of the tensile stress layer, the mole percentage of $Na_2O$ [$Na_2O$] and the mole percentage of $B_2O_3$ [$B_2O_3$] satisfy the following relationship:

0.90%≤[$Na_2O$]-[$B_2O_3$]≤3.10%, preferably, 2.00%≤[$Na_2O$]-[$B_2O_3$]≤3.00%, more preferably, 2.30%≤[$Na_2O$]-[$B_2O_3$]≤3.00%; and/or

in the composition at the center of the chemically strengthened microcrystalline glass or the composition of the tensile stress layer, the mole percentage of $Na_2O$ $[Na_2O]$ and the mole percentage of $Li_2O$ $[Li_2O]$ satisfy the following relationship:

$8.55 \leq [Li_2O]/[Na_2O] \leq 13.85$, preferably, $8.60 \leq [Li_2O]/[Na_2O] \leq 11.00$.

As an optional embodiment, the composition at the center of the chemically strengthened microcrystalline glass or the composition of the tensile stress layer satisfies:

the value of Formula Z is 5.10, 5.09 or 5.12; and/or,
the value of $[Na_2O]-[B_2O_3]$ is 2.36%, 2.93% or 2.96%; and/or,
the value of $[Li_2O]/[Na_2O]$ is 10.92, 8.84 or 8.69.

As an optional embodiment, the mass of the lithium disilicate crystalline phase accounts for more than 70% of all crystalline phases of the chemically strengthened microcrystalline glass.

Preferably, the mass of the lithium disilicate crystalline phase accounts for more than 85% of all crystalline phases of the chemically strengthened microcrystalline glass.

As an optional embodiment, the average grain size of the chemically strengthened microcrystalline glass is below 40nm, preferably, the average grain size is 15nm-35nm; and/or, the crystallinity of the chemically strengthened microcrystalline glass is above 45%. Preferably, the crystallinity of the chemically strengthened microcrystalline glass is 45%-85%, and more preferably, the crystallinity of the chemically strengthened microcrystalline glass is 55%-65%.

As an optional embodiment, the chemically strengthened microcrystalline glass are transparent in the wavelength range of visible light, and preferably, at a thickness of 0.70mm and for light with a wavelength of 550nm, the transmittance of the chemically strengthened microcrystalline glass is $\geq$90.00%, preferably, the transmittance is >90.40%; and/or,

at a thickness of 0.70mm, the haze of the chemically strengthened microcrystalline glass is <0.30%, preferably, the haze is <0.20%; and/or,
at a thickness of 0.70mm, the b value of the chemically strengthened microcrystalline glass is <0.70, preferably, the b value is $\leq$0.60.

As an optional embodiment, the Young's modulus of the chemically strengthened microcrystalline glass is $\geq$100GPa, preferably, the Young's modulus of the chemically strengthened microcrystalline glass is 105GPa-112.50GPa; and/or the Vickers hardness of the chemically strengthened microcrystalline glass is $\geq$650kgf/mm$^2$, and preferably, the Vickers hardness of the chemically strengthened microcrystalline glass is 650kgf/mm$^2$-800kgf/mm$^2$.

As an optional embodiment, the chemically strengthened microcrystalline glass is planar or curved; and/or, the thickness of the chemically strengthened microcrystalline glass is 0.3mm-2mm, preferably, 0.45 mm-0.8 mm; and/or, the chemically strengthened microcrystalline glass does not contain petalite crystalline phase.

As an optional embodiment, the chemically strengthened microcrystalline glass is subjected to high-temperature and high-humidity failure test at a temperature of 85°C and a relative humidity of 85%. The high-temperature and high-humidity failure duration is $\geq$240h, wherein the high-temperature and high-humidity failure duration is the total duration from the beginning of the high-temperature and high-humidity test of the chemically strengthened microcrystalline glass to the appearance of indelible spots or whitish traces in the chemically strengthened microcrystalline glass.

In a second aspect, a cover glass is provided, wherein the cover glass is made of chemically strengthened microcrystalline glass according to any one of the embodiments of the first aspect.

In a third aspect, an electronic device is provided, wherein the electronic device includes the chemically strengthened microcrystalline glass according to any one of the embodiments of the first aspect.

As an optional embodiment, the electronic device includes a housing assembled outside the electronic device, wherein the housing includes the chemically strengthened microcrystalline glass according to any one of the embodiments of the first aspect.

As an optional embodiment, the housing includes a cover of display screen assembled on the front side of the electronic device, wherein the display screen cover includes the chemically strengthened microcrystalline glass according to any one of the embodiments of the first aspect.

As an optional embodiment, the housing includes a rear cover assembled on the rear side of the electronic device, wherein the rear cover includes the chemically strengthened microcrystalline glass according to any one of the embodiments of the first aspect.

As an optional embodiment, the electronic device further includes a camera assembly located inside the housing,

EP 4 707 254 A1

wherein the housing includes a camera protection cover and the camera protection cover is mounted over the camera assembly. The camera protection cover includes the chemically strengthened microcrystalline glass according to any one of the embodiments of the first aspect.

As an optional embodiment, the electronic device further includes a middle frame, wherein the middle frame includes the chemically strengthened microcrystalline glass according to any one of the embodiments of the first aspect.

In some embodiments, the housing can be partially made of chemically strengthened microcrystalline glass, or can be completely made of chemically strengthened microcrystalline glass. According to the present invention, the electronic device can incorporate the chemically strengthened microcrystalline glass according to any one of the embodiments of the first aspect in one or more of a display screen cover, a rear cover, a camera protection cover, or a middle frame.

In a fourth aspect, a glass component is provided, wherein the glass component includes the chemically strengthened microcrystalline glass according to any one of the embodiments of the first aspect.

Compared with the prior art, one or more of the above technical solutions provided by the present invention include the following advantages.

According to the present invention, by making the surface composition and stress structure of chemically strengthened microcrystalline glass with lithium disilicate as the main crystalline phase meet specific relationship, the chemically strengthened microcrystalline glass can achieve good weather resistance while maintaining a high stress level, thereby better ensuring that the chemically strengthened microcrystalline glass meets market application demands.

**BRIEF DESCRIPTION OF THE DRAWINGS**

In order to more clearly illustrate the technical solutions of examples in the present invention, the drawing to be used in examples will be briefly introduced below. It should be understood that the following drawing only shows some examples of the present invention, so they should not be regarded as limiting the scope, for a person of ordinary skill in the art, other drawings can be obtained according to the drawing without inventive efforts.

FIG. 1 is an XRD pattern of microcrystalline glass in Example 1.
FIG. 2 is a comparison diagram of the transmittance curves between the microcrystalline glass and the chemically strengthened microcrystalline glass in Example 1 in the wavelength range of 360nm-740nm.
FIG. 3 is a comparison diagram of XRD patterns between the microcrystalline glass and the chemically strengthened microcrystalline glass in Example 1.
FIG. 4 is a schematic structural diagram of the front side of the electronic device according to the embodiment of the present invention.
FIG. 5 is a schematic structural diagram of the rear side of the electronic device according to the embodiment of the present invention.
FIG. 6 is a schematic structural diagram of the electronic device according to the embodiment of the present invention.
FIG. 7 is a physical comparison diagram of the chemically strengthened microcrystalline glass of Example 1 before and after the high-temperature and high-humidity test, wherein (7a) is the chemically strengthened microcrystalline glass before the high-temperature and high-humidity test, and (7b) is the chemically strengthened microcrystalline glass taken out from 10 days of the high-temperature and high-humidity test.
FIG.8 is a physical comparison diagram of the chemically strengthened microcrystalline glass of Example 2 before and after the high-temperature and high-humidity test, wherein (8a) is the chemically strengthened microcrystalline glass before the high-temperature and high-humidity test, and (8b) is the chemically strengthened microcrystalline glass taken out from 10 days of the high-temperature and high-humidity test.
FIG. 9 is a physical comparison diagram of the chemically strengthened microcrystalline glass of Example 3 before and after the high-temperature and high-humidity test, wherein (9a) is the chemically strengthened microcrystalline glass before the high-temperature and high-humidity test, and (9b) is the chemically strengthened microcrystalline glass taken out from 10 days of the high-temperature and high-humidity test.
FIG. 10 is a physical comparison diagram of the chemically strengthened microcrystalline glass of Comparative Example 1 before and after the high-temperature and high-humidity test, wherein (10a) is the chemically strengthened microcrystalline glass before the high-temperature and high-humidity test, and (10b) is the chemically strengthened microcrystalline glass taken out from 10 days of the high-temperature and high-humidity test.
FIG. 11 is a physical comparison diagram of the chemically strengthened microcrystalline glass of Comparative Example 2 before and after the high-temperature and high-humidity test, wherein (11a) is the chemically strengthened microcrystalline glass before the high-temperature and high-humidity test, and (11b) is the chemically strengthened microcrystalline glass taken out from 10 days of the high-temperature and high-humidity test.

Reference numerals: 1-housing; 11-display screen cover; 12-rear cover; 13-camera protection cover; 2-camera assembly; 3-middle frame; 4-display module.

## DETAILED DESCRIPTION OF EMBODIMENTS

Embodiments of the present invention will be described in detail below with reference to examples, but those skilled in the art will understand that the following examples are only used to illustrate the present invention and should not be regarded as limiting the scope of the present invention. Where specific conditions are not specified in the examples, it shall be carried out according to the conventional conditions or the conditions suggested by the manufacturer. The reagents or instruments used without indicating the manufacturer are conventional products that can be obtained through commercially available purchase.

The endpoints of the range disclosed in the present invention and any values are not limited to the precise range or value; these ranges or values should be understood to include values close to these ranges or values. For numerical ranges, the values between the endpoints of different ranges, between the endpoints of different ranges and individual points, and between individual points themselves can be combined to form one or more new numerical ranges, where the numerical ranges should be considered as specifically disclosed herein. The terms "alternative" and "optional" both mean that it can be comprised or may not be comprised (or can exist or may not exist). The term "and/or" as used herein is inclusive. For example, "A and/or B" means A alone, B alone, or both A and B together.

### Term interpretations and test methods:

In the present invention, the microcrystalline glass is a kind of solid composite material that contains both glass phase and crystalline phase (or also referred to as microcrystalline phase or crystallized phase) and is prepared by targeted and controlled heat treatment of base glass. Microcrystalline glass is also known as glass ceramics or crystallized glass.

In the present invention, the chemically strengthened microcrystalline glass refers to the solid composite material obtained by performing the chemically strengthening treatment on microcrystalline glass. It should be understood that during chemical strengthening treatment, alkali metal ions with larger ion radius (such as potassium ions or sodium ions) in molten salt bath (also referred to as fused salt bath) replace alkali metal ions with smaller ion radius (such as sodium ions or lithium ions) in microcrystalline glass, resulting in exchange ion volume difference, so as to produce compressive stress (also referred to as compression stress) on the surface of microcrystalline glass.

In the present invention, base glass refers to glass that has not been performed on nucleation treatment, crystallization treatment and strengthening treatment, or it is also called basic glass.

In the present invention, the composition at the center of the chemically strengthened microcrystalline glass refers to the composition at or near the center of the depth or thickness of the chemically strengthened microcrystalline glass, that is, the composition of the region in the chemically strengthened microcrystalline glass where ion exchange is not performed. It should be understood that the composition at the center of the chemically strengthened microcrystalline glass is identical or substantially identical to the composition of the microcrystalline glass used to prepare the chemically strengthened microcrystalline glass but before undergoing chemical strengthening treatment.

In the present invention, the wavelength range of visible light refers to 360nm-740nm.

In the present invention, the haze is the percentage of transmitted light intensity that deviates from incident light by more than 2.5° to the total transmitted light intensity.

In the present invention, the primary crystalline phase (also referred to as the main crystalline phase) means the crystalline phase that has a higher weight content (also referred to as weight percentage or mass percentage) than other crystalline phases present in the microcrystalline glass or the chemically strengthened microcrystalline glass.

In the present invention, the main surface refers to the surface with the largest area, such as the top surface or bottom surface of a horizontally placed microcrystalline glass sheet.

In the present invention, the crystallinity refers to the percentage of the total mass of crystalline phases or crystals in microcrystalline glass or chemically strengthened microcrystalline glass to the total mass of microcrystalline glass or chemically strengthened microcrystalline glass, also referred to as the total content of crystalline phases in the microcrystalline glass or chemically strengthened microcrystalline glass.

In the present invention, when light of a specific wavelength is incident on the main surface of the microcrystalline glass or chemically strengthened microcrystalline glass, the light will be reflected, absorbed and transmitted, wherein the ratio of the transmitted light intensity to the incident light intensity is the transmittance.

In the present invention, the D65 light source is a light source for measuring the color of an object irradiated with sunlight, including the ultraviolet region, with a color temperature of 6500K and a color rendering index Ra higher than 90, exhibiting a broad spectral distribution in the visible wavelength region.

In the present invention, the crystallized glass raw material refers to a glass raw material that has undergone heat treatment for a period of time to achieve a certain degree of crystallinity but has not yet reached the target crystallinity, and it can continue to crystallize upon heating to reach the target crystallinity.

In the present invention, CT_LD refers to the tensile stress line density, with units of MPa/mm. It should be understood that after the microcrystalline glass is placed in molten salt bath for ion exchange, a compression stress layer (also referred to as a compressive stress layer) will be formed on the surface of the microcrystalline glass, and a tensile stress layer (also referred to as a stretching stress layer) will be formed inside the microcrystalline glass. In the present invention, during chemical strengthening treatment, alkali metal ions with large radius in molten salt bath are ion-exchanged with alkali metal ions with small radius in microcrystalline glass, thereby forming a compression stress layer on the surface of microcrystalline glass and a tensile stress layer inside the microcrystalline glass, that is, a chemically strengthened microcrystalline glass containing both a compression stress layer and a tensile stress layer is obtained. In the present invention, CT_LD is calculated by the following formula:

$$\mathrm{CT\_LD} \ = \ |\mathrm{CT\_AV}| \times \frac{(1000 \times t - 2 \times \mathrm{DOL\_0})}{t} \quad ,$$

wherein

t is the thickness of chemically strengthened microcrystalline glass, with unit of mm; DOL_0 is the depth of the compression stress layer of chemically strengthened microcrystalline glass, with unit of $\mu$m; |CT_AV| is the absolute value of the average tensile stress of chemically strengthened microcrystalline glass, with unit of MPa. It should be understood that in the calculation formula of tensile stress line density, the data is substituted for calculation according to the above requirements of the units, and the calculated result is obtained without including the units themselves in the actual calculation.

In the present invention, CS_50 refers to the compressive stress value at the depth of 50$\mu$m from the main surface of chemically strengthened microcrystalline glass, with the unit of MPa, as measured by an SLP-2000 stress meter.

In the present invention, |CT_AV| refers to the absolute value of the average tensile stress with the unit of MPa, specifically referring to the absolute value of the average value of all tensile stresses in the tensile stress layer, as measured by an SLP-2000 stress meter.

In the present invention, DOL_0 refers to the depth of the compression stress layer, or the compressive stress layer depth, specifically referring to the distance from any main surface of chemically strengthened microcrystalline glass to the position where the compressive stress near the surface is zero, as measured by SLP-2000 stress meter.

In the present invention, the testing method for the aforementioned stress performance is as follows: when measuring CS_50, DOL_0, and |CT_AV| of the chemically strengthened microcrystalline glass using the SLP-2000 stress meter, the relevant parameters of the stress meter are set as: the wavelength of light source is set to 518nm, the SOC (stress-optic coefficient) is set to 26[(nm/cm)/MPa], the refractive index is set to 1.56, and the exposure time is set to 300 $\mu$sec. After DOL_0 and |CT_AV| are measured, the value of the tensile stress line density (CT_LD) of the chemically strengthened microcrystalline glass is calculated by the above formula of the tensile stress line density.

In the present invention, the b value is used to characterize the yellow-blue value of the material. In the present invention, the b value refers to the transmitted light b value, wherein a positive b value indicates a bluish tint in the material.

In the present invention, Vickers hardness refers to a standard for indicating the hardness of materials proposed by Robert L. Smith and George E. Sandland in 1921 in Vickers Ltd.

In the present invention, the testing method of Vickers hardness is as follows: microcrystalline glass or chemically strengthened microcrystalline glass are made into small pieces with the length, width and thickness of 50mm×50mm×0.70mm, and glass samples with clean surface and no visible scratches, pits and cracks are selected as test samples, and then Vickers hardness is measured by Vickers hardness tester. The Vickers hardness tester used in the test of the present invention is a digital-display and low-load Vickers hardness tester with model VTD405 of Beijing Kewei Technology Co., Ltd. Testing conditions: the load is 300gf and the load duration is 10s, with indentation validity complying with the standard of *GB/T 37900-2019 Test Method for Hardness and Fracture Toughness of Ultra-Thin Glass: Low-Load Vickers Hardness Indentation Method.* Three different positions on the same test sample surface are selected for measurement, and then the average of the three measurement results is recorded as the Vickers hardness result of the test sample.

In the present invention, the Young's modulus is used to characterize the ability of glass to resist elastic deformation under external forces. In the present invention, a UMS-100 ultrasonic material characterization system is used to measure the Young's modulus of the microcrystalline glass via acoustic wave testing.

In the present invention, nucleation treatment refers to the formation of stable crystal nuclei in the base glass through heat treatment; crystallization treatment refers to the precipitation of target crystals or crystalline phases in the base glass through heat treatment.

In the present invention, the thickness of the microcrystalline glass or chemically strengthened microcrystalline glass is measured using a micrometer. It should be understood that, in the thickness direction, the degree of ion exchange changes in gradient from the surface to the center and the whole exchange increment (quality) of Na-K and/or Li-Na is generally not more than 1.5% of the total mass of the sample, so the expansion effect in the thickness direction is extremely slight, which can be approximately considered that the thickness is basically unchanged. That is, before and after chemical strengthening, the thickness change of microcrystalline glass is very small, which can be basically ignored, and the thickness of microcrystalline glass is basically the same as that of chemically strengthened microcrystalline glass.

In the present invention, the dimensions and specifications of microcrystalline glass sheet are measured by a two-dimensional measuring instrument (instrument model: Miyu MY-YXCL-4030).

In the present invention, the crystalline phases, crystallinity, and average grain size of the microcrystalline glass or chemically strengthened microcrystalline glass are determined by XRD testing. The details are as follows:

(1) XRD test: the microcrystalline glass or chemically strengthened microcrystalline glass of the present invention is crushed and ground into samples with particle size less than 75μm. The ground sample is then analyzed using an X-ray diffractometer to obtain XRD diffraction peak curves and XRD diffraction data. The X-ray diffractometer adopted in the present invention is Shimadzu XRD-6100, the target material is copper, $2\theta=10°-50°$, the scanning speed is 6°/min, the working voltage is 40kV and the working current is 30mA.
(2) Determination of crystalline phase: the XRD diffraction data are analyzed using Jade software (JADE Standard 8.6) to identify the crystalline phases in the sample.
(3) Determination of crystallinity: the test results of XRD (RAW format) are imported into Jade software for fitting and calculation to determine the sample's crystallinity.
(4) Determination of average grain size: according to Scherrer formula $D = k\lambda/(\beta\cos\theta)$, the average grain size (also called average crystal size) of the sample can be calculated by using the result data obtained from XRD test, wherein $\lambda$ is the X-ray wavelength, $\lambda = 0.154056$nm, $\beta$ is the full width at half maximum of the diffraction peak, $k = 0.89$, and $\theta$ is the Bragg diffraction angle. Specifically, the file of the RAW (diffraction pattern) output from the XRD instrument is curve-fitted in Jade software, and Jade outputs a fitting report. Based on the angle $2\theta$ value and Peak FWHM value corresponding to each diffraction peak in the fitting report, with converting the Peak FWHM value to the radian system: $\beta=(FWHM/180\times3.14)$, the grain size of each diffraction peak is calculated by Scherrer formula $D=K\lambda/(\beta\cos\theta)$, and then the grain sizes are averaged to obtain the average grain size.

In the present invention, referring to the national standard of *GB/T 7962.12-2010 Test methods for colorless optical glass-Part 12: Internal transmittance,* the transmittance, haze and b value of the microcrystalline glass of the present invention are tested by a haze meter. Specifically, the transmittance, haze and b value of five sheets of microcrystalline glass in the same batch for light with different wavelengths are tested by a haze meter. The average values of b value and haze measured by five sheets of microcrystalline glass are recorded as the b value result and haze result of microcrystalline glass. The average transmittance of five sheets of microcrystalline glass under 550nm wavelength light is taken as the transmittance result of microcrystalline glass under 550nm wavelength light. The haze meter used in the test of the present invention is Konica Minolta CM-3600A spectrophotometer, wherein the light receiving optical system is transmission, and the spectroscopic method is plane folded grating, the wavelength range is 360nm-740nm, and the wavelength interval is 10nm, the lighting source is pulsed xenon lamp × 4, the ambient temperature of the instrument is 24°C and the air humidity is 40%.

In the present invention, among a plurality of chemically strengthened microcrystalline glass samples in the same example or the same comparative example, the anti-abrasive-paper drop height measured by each sample is added and divided by the number of samples measured, which is recorded as the average anti-abrasive-paper drop height of the tested chemically strengthened microcrystalline glass, and the value is adopted to characterize the drop damage resistance of the chemically strengthened microcrystalline glass. Specifically, at least 10 samples from each batch are taken for testing the average anti-abrasive paper drop height.

$$\langle h\rangle n = \frac{1}{n}\sum_{i=1}^{n} hi,$$

wherein

n is the number of sample plates of glass tested in each batch, and *hi* is the anti-abrasive-paper drop height of a single sample plate, and

the test method of the anti-abrasive-paper drop height of the sample is as follows.

Step 1: attaching 80-mesh abrasive paper on the lower surface of the 181g model machine, and placing the model machine on the Lvtu LT-SKDL-CD drop tester.

Step 2: placing the chemically strengthened microcrystalline glass sample to be tested with a length, width and thickness of 50mm×50mm×0.7mm directly under the model machine, so that the chemically strengthened microcrystalline glass sample faces the abrasive paper, and making the model machine impact and drop at a certain drop height, so as to impact the chemically strengthened microcrystalline glass sample directly below the model machine. If the chemically strengthened microcrystalline glass sample is not broken, the drop height of the model machine is raised according to a certain rule, then the model machine is made to continue impact and drop, impacting the chemically strengthened microcrystalline glass sample directly below the model machine, until the chemically strengthened microcrystalline glass sample is broken. For example, the drop height of the model machine starts from 0.4m, and a drop impact is performed on the sample once, and if it is not broken, the height of 0.1m of the model machine is raised each time and dropping is performed again, and the above process is repeated until the chemically strengthened microcrystalline glass sample is broken.

Step 3: recording the previous drop height of the chemically strengthened microcrystalline glass sample when it is broken as the anti-abrasive-paper drop height. For example, if the method that the drop height is increased by 0.1m each time is used and the drop height when the sample is broken is 0.5m, the anti-abrasive-paper drop height of the sample is 0.4m.

In the present invention, the method for testing the mass percentage of $Na_2O$ on the surface of the chemically strengthened microcrystalline glass is as follows: the content of Na element on the surface of chemically strengthened microcrystalline glass is measured by X-ray fluorescence spectrometer (XRF), and then the mass percentage of $Na_2O$ on the surface is obtained by calculating. The model of the equipment used is Thermo Scientific ARL PERFORM'X, the target material is Rh (rhodium), X-ray tube voltage is 30kV, the current is 80mA, the collimator is 0.40, the crystal is AxO3, the detector is FPC, the test range is a circle with a diameter of 29mm, and the test method is X_UQ in OXSAS analysis software.

In the present invention, the method for testing the mass percentage of $K_2O$ on the surface of the chemically strengthened microcrystalline glass is as follows: the content of K element on the surface of chemically strengthened microcrystalline glass is measured by X-ray fluorescence spectrometer (XRF), and then the mass percentage of $K_2O$ on the surface is obtained by calculating. The model of the equipment used is Thermo Scientific ARL PERFORM'X, the target material is Rh (rhodium), X-ray tube voltage is 40kV, the current is 60mA, the collimator is 0.15, the crystal is LiF200, the detector is FPC, the test range is a circle with a diameter of 29mm, and the test method is X_UQ in OXSAS analysis software.

In the present invention, XRF testing is performed without standards, and the concentrations of elements with atomic numbers of 6 and below or their oxides in the chemically strengthened microcrystalline glass are not measured. For testing, the chemically strengthened microcrystalline glass sheet is cut to an appropriate size (e.g., 34 mm × 34 mm), placed flat in the sample box to cover the test aperture, and then the test can be carried out.

In the present invention, the high-temperature and high-humidity failure duration of chemically strengthened microcrystalline glass is tested at the test temperature of 85°C and the relative humidity of 85%, that is, the high temperature and high humidity failure test is carried out, and the weather resistance of chemically strengthened microcrystalline glass is characterized by the high temperature and high humidity failure test results. The high-temperature and high-humidity failure duration is the total duration from the beginning of the high-temperature and high-humidity test of the chemically strengthened microcrystalline glass to the appearance of indelible spots or whitish traces in the chemically strengthened microcrystalline glass.

In the present invention, the primary objective is to determine whether the high-temperature and high-humidity failure duration of the chemically strengthened microcrystalline glass exceeds 240h (10 days). Specifically, the samples of chemically strengthened microcrystalline glass are placed into a temperature and humidity alternating test chamber with a temperature of 85°C and a relative humidity of 85%, and the initial loading time is recorded. Then every 24 h, the chemically strengthened microcrystalline glass sample is taken out, the surface of the chemically strengthened microcrystalline glass sample is wiped with a dust-free cloth, and the sample is observed to see whether there are spots and/or whitish traces that cannot be wiped off. If no spots and/or whitish traces that cannot be wiped off are observed in the sample, the sample is returned to the temperature and humidity alternating test chamber and is left for the next sampling observation. If after 240h of the loading test, there are still no spots and/or whitish traces that cannot be wiped off in the chemically strengthened microcrystalline glass sample, it indicates that the sample has passed the high-temperature and high-humidity test and it is in OK status and then it is recorded as qualified, thus indicating that the high-temperature and high-humidity failure duration of the chemically strengthened microcrystalline glass exceeds 240h. If spots and/or whitish traces that cannot be wiped off are observed in the sample after the loading test before or at 240h, it indicates that the chemically strengthened microcrystalline glass failed the high-temperature and high-humidity test, and it is in NG state and then it is recorded as unqualified, thus indicating that the high-temperature and high-humidity failure duration of the chemically strengthened microcrystalline glass is less than 240h. The temperature and humidity alternating test chamber used in the present invention is QTH_80C Quanyi temperature and humidity alternating test chamber.

Without being limited by any theory, lithium disilicate microcrystalline glass with lithium disilicate crystalline phase as the main crystalline phase mainly undergoes sodium-lithium ion exchange during chemical strengthening, so as to improve the deep compression stress and the compressive stress layer depth of the glass. However, after the exchange, the microcrystalline glass is easy to form a sodium-rich layer on the surface of the glass. If the sodium content on the surface is relatively high, the environmental durability (also referred to as weather resistance) of the prepared chemically strengthened microcrystalline glass will be poor. When it is exposed to the sweat conditions for a long time or it continues to be used after exposure to humid environment, the surface smoothness of the chemically strengthened microcrystalline glass tends to degrade, becoming rougher, and more severely, the surface can be hazed or whitening, or forming unremovable spots. These conditions not only reduce the tactile experience for users when touching the screen but also significantly impair the display quality and appearance of the glass screen due to the issues of haze, whitening, and spots. Moreover, if the issues of spots, haze, or whitening occur in the camera position, the imaging performance of the mobile phone can be severely affected and the service life of the equipment is reduced. However, if the surface sodium content of chemically strengthened microcrystalline glass obtained after chemical strengthening (ion exchange) is too low, the compressive stress formed by sodium-lithium ion exchange will be relatively reduced, consequently leading to decreased mechanical strength of the chemically strengthened microcrystalline glass that fails to meet application requirements.

In view of this, to enable the chemically strengthened microcrystalline glass to maintain both high stress and excellent mechanical strength performance while achieving good weather resistance, a chemically strengthened microcrystalline glass with good weather resistance and high stress is provided in the present invention. According to the present invention, a chemically strengthened microcrystalline glass that maintains high stress levels, ensures high mechanical strength performance, and exhibits good environmental durability or weather resistance is provided by controlling the surface composition and stress of the chemically strengthened microcrystalline glass with lithium disilicate as the main crystalline phase to meet specific relationships. Understandably, the surface composition can be the material composition or component distribution of the material composition of the surface of the base glass, microcrystalline glass or chemically strengthened microcrystalline glass, the surface composition can further be the mass percentage of a certain component, the molar percentage of a certain component, the mass percentage relationship between two or more material components, the mass content relationship between two or more material components, or the surface composition can further be the molar content relationship between two or more material components, a combination of the aforementioned items, and other factors. For example, the mass percentage of $Na_2O$ on the surface of chemically strengthened microcrystalline glass or the mass percentage of $K_2O$ on the surface of the chemically strengthened microcrystalline glass; for another example, the content relationship between $Na_2O$ on the surface of chemically strengthened microcrystalline glass and $K_2O$ on the surface of the chemically strengthened microcrystalline glass, and for another example, the mass percentage relationship between $Na_2O$ on the surface of chemically strengthened microcrystalline glass and $K_2O$ on the surface of the chemically strengthened microcrystalline glass.

In some embodiments of the present invention, a chemically strengthened microcrystalline glass is provided. The chemically strengthened microcrystalline glass contains a lithium disilicate crystalline phase, wherein the lithium disilicate crystalline phase has a larger mass percentage than other crystalline phases existing in the chemically strengthened microcrystalline glass. The chemically strengthened microcrystalline glass has a compression stress layer on the surface and a tensile stress layer inside. The chemically strengthened microcrystalline glass satisfies:

$N = n*(CT\_LD-50000)/10000$, $-32.5 < N < 15$, preferably, $-28.0 \leq N \leq 0$, and more preferably, $-20.0 \leq N \leq -2.5$, wherein $n =$ (mass percentage of $Na_2O$ on the surface of the chemically strengthened microcrystalline glass / mass percentage of $K_2O$ on the surface of the chemically strengthened microcrystalline glass)$^2$. The mass percentage of $Na_2O$ on the surface of the chemically strengthened microcrystalline glass and the mass percentage of $K_2O$ on the surface of the chemically strengthened microcrystalline glass are determined by XRF; $CT\_LD$ represents the tensile stress line density, and the unit is MPa/mm. In Formula N, the data is substituted for calculation according to the above requirements of the units, and the calculated result is obtained without including the units themselves in the actual calculation.

The crystalline phase of lithium disilicate ($Li_2Si_2O_5$) is an orthorhombic crystal based on $[Si_2O_5]$ tetrahedral arrays, with flat or plate-like crystal morphology. Within the microcrystalline glass, the lithium disilicate crystal forces the path of cracks to distort when they pass through the crystal, so as to prevent the crack from spreading, thus improving the strength and fracture toughness of the microcrystalline glass. Simultaneously, the refractive index of lithium disilicate crystals closely matches that of the glass matrix (e.g., the base glass used to prepare the microcrystalline glass in the present invention), making it an ideal crystalline phase for producing highly transparent microcrystalline glass. In the present invention, the microcrystalline glass contains a structure with lithium disilicate as the main crystalline phase, which facilitates achieving high intrinsic strength (also referred to as inherent strength) and excellent optical properties.

In the present invention, by making the chemically strengthened microcrystalline glass meet the requirements of specific crystalline phase structure and the requirements of Formula N, the chemically strengthened microcrystalline glass maintains good weather resistance while under the condition of achieving high stress levels, thereby better guaranteeing that the chemically strengthened microcrystalline glass meets application demands.

In some embodiments, the value of the Formula N can be -30 to 10, -25 to 5, -20 to 0, -15 to -2 or -10 to -2.5, etc. In some embodiments, the value of the Formula N can be -32.5, -30, -28.4, -28, -26, -24, -22, -20, -18, -16, -14, -12, -10, -8, -6, -4, -2.5, -2, 0, 2, 4, 6, 8, 10, 12, 14, 15, -2.52, -4.07, -4.47, -4.75, -10.59, -11.90 or -12.73, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

In some embodiments of the present invention, the chemically strengthened microcrystalline glass satisfies: $45000MPa/mm \leq CT\_LD \leq 52000MPa/mm$, preferably, $45900MPa/mm \leq CT\_LD \leq 50000MPa/mm$, and more preferably, $47500MPa/mm \leq CT\_LD \leq 50000MPa/mm$. By ensuring that the CT_LD of the chemically strengthened microcrystalline glass is not less than 45000 MPa/mm, it is advantageous to guarantee sufficiently dense storage of tensile stress within the chemically strengthened microcrystalline glass. This consequently ensures a relatively high surface stress level, thereby facilitating the stress structure's improvement effect on mechanical strength performance and guaranteeing excellent damage resistance performance, such as superior drop damage resistance to rough-surface, so as to meet market demands.

In some embodiments, the CT_LD of chemically strengthened microcrystalline glass can be 45000MPa/mm-50000MPa/mm, 45500MPa/mm-49500MPa/mm, 46000MPa/mm-49000MPa/mm, 46500MPa/mm-48500MPa/mm, or 46000MPa/mm-48000MPa/mm. In some embodiments, the CT_LD of chemically strengthened microcrystalline glass can be 45000MPa/mm, 45900MPa/mm, 46000MPa/mm, 47000MPa/mm, 47517.24MPa/mm, 48185.39MPa/mm, 49692.43MPa/mm, 47636.26 MPa/mm, 47919.69 MPa/mm, 47679.19MPa/mm, 48097.14MPa/mm, 48000MPa/mm, 49000MPa/mm, 49700MPa/mm, 50000MPa/mm, 51000MPa/mm or 52000Mpa/mm, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

In some embodiments of the present invention, as measured by XRF and calculated in terms of oxide mass percentage, the mass percentage of $Na_2O$ on the surface of the chemically strengthened microcrystalline glass is 5%-8.5%, preferably, 5.5%-7.5%; and/or, in some embodiments of the present invention, as measured by XRF and calculated in terms of oxide mass percentage, the mass percentage of $K_2O$ on the surface of the chemically strengthened microcrystalline glass is 0.7%-2.0%, preferably, 0.7%-1.5%. By making the surface K element or surface Na element of chemically strengthened microcrystalline glass meet a specific range, it is beneficial for chemically strengthened microcrystalline glass to achieve high stress level and good weather resistance at the same time.

In some embodiments, as measured by XRF and calculated in terms of oxide mass percentage, the mass percentage of $Na_2O$ on the surface of the chemically strengthened microcrystalline glass can be 5%, 5.30%, 6.12%, 7.00%, 5.21%, 6.32%, 5.17%, 6.36%, 7%, 7.5%, 8% or 8.5%, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

In some embodiments, as measured by XRF and calculated in terms of oxide mass percentage, the mass percentage of $K_2O$ on the surface of the chemically strengthened microcrystalline glass can be 0.7%, 1.25%, 0.81%, 0.77%, 1.24%, 0.80%, 1.26%, 1.5%, 1.8% or 2.0%, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

In some embodiments of the present invention, in terms of oxide mass percentage, in the composition at the center of the chemically strengthened microcrystalline glass or the composition of the tensile stress layer, the mass percentage of $Na_2O$ is 3%-3.5%, preferably, the mass percentage of $Na_2O$ is 3.1%-3.2% It should be understood that in the present invention, in the composition at the center of the chemically strengthened microcrystalline glass or the composition of the tensile stress layer, the mass percentage of $Na_2O$ is 3%-3.5%, indicating that the mass percentage of $Na_2O$ is

3%-3.5% in the composition of the microcrystalline glass used for preparing the chemically strengthened microcrystalline glass, the microcrystalline glass that is not chemically strengthened or the base glass.

In some embodiments, in terms of oxide mass percentage, in the composition at the center of the chemically strengthened microcrystalline glass or the composition of the tensile stress layer, the mass percentage of $Na_2O$ can be 3.1%-3.4%, 3.1%-3.3% or 3%-3.2%. In some embodiments, in terms of oxide mass percentage, in the composition at the center of the chemically strengthened microcrystalline glass or the composition of the tensile stress layer, the mass percentage of $Na_2O$ can be 3%, 3.1%, 3.3%, 3.4%, 3.5%, 3.11%, 3.12%, 3.13%, 3.14%, 3.15%, 3.16%, 3.17%, 3.18%, 3.19% or 3.2%, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

In some embodiments of the present invention, in the chemically strengthened microcrystalline glass, the Na ion concentration changes at least in a part of the compression stress layer and reaches the minimum Na ion concentration at the contact with the tensile stress layer, and the chemically strengthened microcrystalline glass satisfies:

$Y=\Delta C\times((CT\_LD-50000)/100)^2$, Y<60, preferably, $Y\leq50$, and more preferably, $Y\leq20$, wherein $\Delta C$ represents the difference between the mass percentage of $Na_2O$ on the surface of the chemically strengthened microcrystalline glass and the mass percentage of $Na_2O$ at the center of the chemically strengthened microcrystalline glass, with the mass percentage of $Na_2O$ on the surface of the chemically strengthened microcrystalline glass being measured by XRF; CT\_LD represents the tensile stress line density, and the unit is MPa/mm. In Formula Y, the data is substituted for calculation according to the above requirements of the units, and the calculated result is obtained without including the units themselves in the actual calculation.

In the present invention, by ensuring the chemically strengthened microcrystalline glass satisfies specific crystalline phase structures and meets the requirements of Formula Y, it facilitates achieving high stress levels in the chemically strengthened microcrystalline glass.

In some embodiments, the value of Formula Y can be <60, $\leq55$, $\leq50$, $\leq45$, $\leq40$, $\leq35$, $\leq30$, $\leq25$, $\leq20$, $\leq15$, $\leq10$ or $\leq5$. In some embodiments, the value of Formula Y can be 0.1, 1, 2, 3, 4, 5, 6, 7, 8, 9, 10, 11, 12, 13, 14, 15, 16, 17, 18, 19, 20, 22, 24, 26, 28, 30, 35, 40, 45, 50, 55, 60, 0.36, 10.14, 11.58, 11.88, 13.02, 13.25 or 14.84, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

In some embodiments of the present invention, the chemically strengthened microcrystalline glass satisfies: $75MPa\leq|CT\_AV|\leq120MPa$, preferably, $77MPa\leq|CT\_AV|\leq90MPa$, where $|CT\_AV|$ represents the absolute value of the average tensile stress. By keeping the $|CT\_AV|$ of chemically strengthened microcrystalline glass at an appropriate level, it is beneficial to ensure that the chemically strengthened microcrystalline glass possess an expected tensile stress layer distribution structure and it is beneficial to ensure a relatively high surface stress level. The higher the surface compressive stress level is, the greater the residual energy from drop, compression, puncture, impact, or collision can be offset, thereby ensuring the chemically strengthened microcrystalline glass exhibits excellent damage resistance performance.

In some embodiments, the $|CT\_AV|$ of chemically strengthened microcrystalline glass can be 80MPa-115MPa, 85MPa-110MPa, 90MPa-105MPa or 93MPa-102MPa. In some embodiments, the $|CT\_AV|$ of chemically strengthened microcrystalline glass can be 75MPa, 80MPa, 85MPa, 90MPa, 95MPa, 100MPa, 105MPa, 110MPa, 115MPa, 120MPa, 78.26MPa, 79.83MPa, 84.20MPa, 79.01MPa, 80.77MPa, 77.61MPa or 79.23MPa, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

In some embodiments of the present invention, the chemically strengthened microcrystalline glass satisfies: DOL\_0 is 0.18t-0.25t, preferably, 0.20t-0.25t, where DOL\_0 represents the depth of the compression stress layer and t represents the thickness of the chemically strengthened microcrystalline glass. By maintaining an appropriate proportional relationship between the depth of the compression stress layer and the thickness of the chemically strengthened microcrystalline glass, it is advantageous to ensure the chemically strengthened microcrystalline glass achieves a better stress distribution state, thus facilitating the stress structure's enhancement effect on mechanical strength performance.

In some embodiments, the value of DOL\_0/t of chemically strengthened microcrystalline glass can be 0.18, 0.19, 0.2, 0.21, 0.22, 0.23, 0.24 or 0.25, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

In some embodiments of the present invention, the chemically strengthened microcrystalline glass satisfies: CS_50 is 150MPa-250MPa, preferably, 160 MPa-180 MPa, where CS_50 refers to the compressive stress value at the depth of $50\mu m$ from the main surface of chemically strengthened microcrystalline glass. By maintaining the relatively high surface stress level of the chemically strengthened microcrystalline glass, more residual energy from drops, compression, punctures, impacts, or collisions can be offset, thereby ensuring the chemically strengthened microcrystalline glass exhibits excellent damage resistance performance, such as superior drop resistance.

In some embodiments, the CS_50 of the chemically strengthened microcrystalline glass can be 150MPa, 160MPa, 170MPa, 180MPa, 190MPa, 210MPa, 220MPa, 230MPa, 240MPa, 250MPa, 162.81MPa, 166.33MPa, 170.25MPa, 165.17MPa, 169.43MPa, 167.89MPa, 170.28MPa or 200MPa, or a numerical value within a numerical range formed by taking any two of the aforementioned specific numerical values as endpoints, as long as the chemically strengthened microcrystalline glass with the desired properties of the present invention can be obtained. It should be understood that in a specific embodiment, any of the above ranges can be combined with any other range, as long as the chemically strengthened microcrystalline glass with the desired properties of the present invention can be obtained.

It should be understood that the chemically strengthened microcrystalline glass in the present invention is made of microcrystalline glass through chemical strengthening treatment, and unless excessive ion exchange treatment is performed, the composition and phase assemblage in regions deeper than the compressive stress layer (DOL) in chemically strengthened microcrystalline glass-such as at the center of the chemically strengthened microcrystalline glass or within the tensile stress layer-remain identical or substantially identical to those of the microcrystalline glass. Compared with the microcrystalline glass before chemical strengthening treatment (chemical strengthening treatment involves ion exchange), the composition at the surface of microcrystalline glass products after chemical strengthening treatment can be different from that of microcrystalline glass before chemical strengthening treatment. This is because when chemical strengthening treatment is carried out, one type of alkali metal ions (for example, $Li^+$ or $Na^+$) on the surface of the freshly formed microcrystalline glass is replaced by larger alkali metal ions (for example, $Na^+$ or $K^+$) respectively. However, in the embodiment, the glass composition and phase assemblage at or near the depth or thickness center of the microcrystalline glass product still have the glass composition and phase assemblage of the freshly formed microcrystalline glass. That is to say, in the present invention, the composition (e.g., the composition of the tensile stress layer) and the phase assemblage at the center of the chemically strengthened microcrystalline glass obtained through chemical strengthening treatment are the same or basically the same as those of the microcrystalline glass without chemical strengthening treatment.

In the present invention, the microcrystalline glass used to prepare chemically strengthened microcrystalline glass can be prepared by heat treatment of the base glass, and the composition of the base glass is the same or basically the same as that of the microcrystalline glass in terms of mole percentage of oxides.

In some embodiments of the present invention, in terms of oxide molar percentage, the composition at the center of the chemically strengthened microcrystalline glass or the composition of the tensile stress layer, or the composition of the microcrystalline glass used for preparing the chemically strengthened microcrystalline glass, or the composition of the base glass includes: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.80%-3.20%, $B_2O_3$: 0-1.00%, and $Li_2O$: 25.32%-26.52%. By satisfying the specific glass composition, it is beneficial to obtain microcrystalline glass satisfying the specific crystalline phase structure and chemically strengthened microcrystalline glass satisfying the specific stress structure. In a specific embodiment, any of the above ranges can be combined with any other range, as long as the chemically strengthened microcrystalline glass with the desired properties of the present invention can be obtained.

In the present invention, $SiO_2$ is an essential component to form a glass network structure and one of the main components to form a lithium disilicate crystal. The higher the content of $SiO_2$ in the glass system, the denser the network structure of the glass phase. Correspondingly, the mechanical strength of microcrystalline glass will be higher, the coefficient of thermal expansion will be smaller, and the heat resistance, dielectric properties and chemical stability will be better. However, if the content of $SiO_2$ is too high, the melting temperature of the base glass will be higher and the melting viscosity will be higher, increasing the molding difficulty of the base glass. If the content of $SiO_2$ is too low, the weather resistance of glass will be reduced. Therefore, to balance the formability of the glass with its excellent properties, in the present invention, in the composition at the center of the chemically strengthened microcrystalline glass or the composition of the tensile stress layer, or the composition of the microcrystalline glass used for preparing the chemically strengthened microcrystalline glass, or the composition of the base glass, the mole percentage of $SiO_2$ is 61.50%-63.40%, preferably, 61.50%-63.30%, more preferably, 62.00%-62.60%.

In some embodiments of the present invention, in terms of oxide molar percentage, in the composition at the center of the chemically strengthened microcrystalline glass or the composition of the tensile stress layer, or the composition of the microcrystalline glass used for preparing the chemically strengthened microcrystalline glass, or the composition of the base glass, the content of $SiO_2$ can be 62.87%, 62.88%, 63.25%, 63.26%, 62.38%, 62.27%, 62.44%, 62.45%, 62.22%, 63.17%, 61.50%, 61.60%, 61.70%, 61.80%, 61.90%, 62.00%, 62.10%, 62.20%, 62.30%, 62.40%, 62.50%, 62.60%, 62.70%, 62.80%, 62.90%, 63.00%, 63.10%, 63.20%, 63.30%, 63.40%, 62.35% or 62.52%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In the present invention, $Al_2O_3$ is a component that forms the glass network structure. A proper amount of $Al_2O_3$ is beneficial to improve the chemical strengthening effect of microcrystalline glass, improve the weather resistance of glass, and promote the ion exchange in the chemical strengthening process to a certain extent. However, excessive $Al_2O_3$ will increase the viscosity of glass and easily lead to the precipitation of other crystalline phases, such as petalite, thus affecting the crystalline phase structure of microcrystalline glass. Therefore, in order to obtain the desired crystalline phase structure and improve the chemical strengthening effect of the microcrystalline glass, in the present invention, the molar percentage of $Al_2O_3$ is 2.75%-2.99% in the composition at the center of the chemically strengthened microcrystalline glass or the composition of the tensile stress layer, or the composition of the microcrystalline glass used for preparing the chemically strengthened microcrystalline glass, or the composition of the base glass.

In some embodiments of the present invention, in terms of oxide molar percentage, in the composition at the center of the chemically strengthened microcrystalline glass or the composition of the tensile stress layer, or the composition of the microcrystalline glass used for preparing the chemically strengthened microcrystalline glass, or the composition of the base glass, the content of $Al_2O_3$ can be 2.75%, 2.77%, 2.79%, 2.81%, 2.83%, 2.85%, 2.86%, 2.87%, 2.89%, 2.91%, 2.93%, 2.94%, 2.95%, 2.97%, 2.99% or 2.92%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In the present invention, $P_2O_5$ acts as a nucleating agent to promote homogeneous nucleation in the glass. When its content is either insufficient or excessive, it will lead to poor crystallization effect, affecting the optical properties of the obtained microcrystalline glass, and reducing the transparency of the microcrystalline glass. Therefore, to achieve the desired crystalline phase structure and consequently realize both excellent optical properties and mechanical strength performance, in the present invention, in the composition at the center of the chemically strengthened microcrystalline glass or the composition of the tensile stress layer, or the composition of the microcrystalline glass used for preparing the chemically strengthened microcrystalline glass, or the composition of the base glass, the mole percentage of $P_2O_5$ is 0.91%-1.91%, preferably, 1.20%-1.91%, and more preferably, 1.30%-1.60%.

In some embodiments of the present invention, in terms of oxide molar percentage, in the composition at the center of the chemically strengthened microcrystalline glass or the composition of the tensile stress layer, or the composition of the microcrystalline glass used for preparing the chemically strengthened microcrystalline glass, or the composition of the base glass, the content of $P_2O_5$ can be 0.91%, 0.95%, 1.00%, 1.05%, 1.10%, 1.15%, 1.20%, 1.25%, 1.30%, 1.35%, 1.40%, 1.45%, 1.50%, 1.55%, 1.60%, 1.65%, 1.70%, 1.75%, 1.80%, 1.85%, 1.41%, 1.53%, 1.54% or 1.91%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In the present invention, $ZrO_2$ is an intermediate oxide in forming of glass. A proper amount of $ZrO_2$ can improve the chemical stability of microcrystalline glass, increasing the hardness of microcrystalline glass, the scratch resistance and drop resistance of microcrystalline glass, and improving the weather resistance of glass. At the same time, due to its high cationic charge and strong field strength, $ZrO_2$ has a great accumulation effect on the glass structure, and is often used as a nucleating agent in microcrystalline glass. However, if the content of $ZrO_2$ is too high, it will lead to the phase separation of glass, or it is not conducive to obtaining microcrystalline glass with excellent optical properties. Therefore, in order to obtain microcrystalline glass with excellent optical properties and high mechanical strength, in the present invention, in the composition at the center of the chemically strengthened microcrystalline glass or the composition of the tensile stress layer, or the composition of the microcrystalline glass used for preparing the chemically strengthened microcrystalline glass, or the composition of the base glass, the mole percentage of $ZrO_2$ is 4.20%-4.85%, preferably, 4.20%-4.60%.

In some embodiments of the present invention, in terms of oxide molar percentage, in the composition at the center of the chemically strengthened microcrystalline glass or the composition of the tensile stress layer, or the composition of the microcrystalline glass used for preparing the chemically strengthened microcrystalline glass, or the composition of the base glass, the content of $ZrO_2$ can be 4.20%, 4.35%, 4.40%, 4.45%, 4.50%, 4.55%, 4.60%, 4.65%, 4.70%, 4.75%, 4.74%, 4.84%, 4.33%, 4.34%, 4.85% or 4.80%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In the present invention, $Na_2O$ is an oxide outside the network. An appropriate amount of $Na_2O$ can provide free oxygen, improving the viscosity of glass, promoting the melting and clarification of glass liquid, and at the same time, adjusting the chemical strengthening rate. However, excessive $Na_2O$ will not only reduce the crystallinity of microcrystalline glass, but also affect the chemical strengthening effect of microcrystalline glass. Therefore, in order to optimize the formability of the base glass and the chemical strengthening effect of the microcrystalline glass, in the present invention, in the composition at the center of the chemically strengthened microcrystalline glass or the composition of the tensile stress layer, or the composition of the microcrystalline glass used for preparing the chemically strengthened microcrystalline glass, or the composition of the base glass, the mole percentage of $Na_2O$ is 1.80%-3.20%, preferably, 1.85%-3.05%, and more preferably, 2.20%-3.00%.

In some embodiments of the present invention, in terms of oxide molar percentage, in the composition at the center of the chemically strengthened microcrystalline glass or the composition of the tensile stress layer, or the composition of the microcrystalline glass used for preparing the chemically strengthened microcrystalline glass, or the composition of the base glass, the content of $Na_2O$ can be 1.80%, 1.85%, 1.90%, 1.95%, 2.00%, 2.05%, 2.10%, 2.15%, 2.20%, 2.25%, 2.30%, 2.35%, 2.40%, 2.45%, 2.50%, 2.55%, 2.60%, 2.65%, 2.70%, 2.75%, 2.80%, 2.85%, 2.90%, 2.95%, 3.00%, 3.20%, 2.36%, 2.96%, 3.01%, 2.93% or 3.05%, or a numerical value within a numerical range formed by taking any two of the aforementioned specific numerical values as endpoints, as long as the microcrystalline glass and chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In the present invention, $B_2O_3$ as a fluxing agent can reduce the high-temperature viscosity of glass, mitigating the difficulty of melting caused by $ZrO_2$, and reducing the sag temperature of glass. However, excessive $B_2O_3$ can easily lead to a decrease of the transparency of microcrystalline glass. Furthermore, $B_2O_3$ forms different structures at varying concentrations, significantly affecting the weather resistance of glass. Specifically, it manifests as: in the condition of lower concentrations of $B^{3+}$ ions, $B^{3+}$ ions occupy $[BO_4]$ tetrahedron, reconnecting the broken bonds generated by alkali metal ions in glass, thus facilitating the improvement of weather resistance. With the increase of $B_2O_3$ content, the structure of $B^{3+}$ ion is transformed into $[BO_3]$ triangle, conversely decreasing the weather resistance. Therefore, to optimize the formability of the base glass while achieving microcrystalline glass with desired properties, in the present invention, in the composition at the center of the chemically strengthened microcrystalline glass or the composition of the tensile stress layer, or the composition of the microcrystalline glass used for preparing the chemically strengthened microcrystalline glass, or the composition of the base glass, the mole percentage of $B_2O_3$ is 0-1.00%, preferably, 0-0.65%.

In some embodiments of the present invention, in terms of oxide molar percentage, in the composition at the center of the chemically strengthened microcrystalline glass or the composition of the tensile stress layer, or the composition of the microcrystalline glass used for preparing the chemically strengthened microcrystalline glass, or the composition of the base glass, the content of $B_2O_3$ can be 0, 0.05%, 0.10%, 0.15%, 0.20%, 0.25%, 0.30%, 0.35%, 0.40%, 0.45%, 0.50%, 0.55%, 0.65%, 0.70%, 0.80%, 0.90%, 1.00% or 0.60%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In the present invention, $Li_2O$ is an essential component to form the lithium disilicate crystalline phase as the main crystalline phase, and it is also an essential component to provide lithium ions for ion exchange in the process of chemical strengthening. A proper amount of $Li_2O$ is not only beneficial to optimize the viscosity of glass, promoting the melting and clarification of glass liquid, but also to ensure the desired content of lithium disilicate crystals. At the same time, $Li_2O$ can further provide alkali metal lithium ions for ion exchange with large radius ions (such as sodium ions) in the fused salt bath. Thus, it is an important factor that affects the stress level of chemically strengthened microcrystalline glass. However, excessive $Li_2O$ will deteriorate the optical properties of microcrystalline glass. Therefore, in order to optimize the formability of the base glass, obtain microcrystalline glass with the desired structure, and enhance the chemical strengthening effect of the microcrystalline glass, in the present invention, in the composition at the center of the chemically strengthened microcrystalline glass or the composition of the tensile stress layer, or the composition of the microcrystalline glass used for preparing the chemically strengthened microcrystalline glass, or the composition of the base glass, the molar percentage of $Li_2O$ is 25.32%-26.52%, preferably, 25.52%-26.52%, and more preferably, 25.52%-26.00%.

In some embodiments of the present invention, in terms of oxide molar percentage, in the composition at the center of the chemically strengthened microcrystalline glass or the composition of the tensile stress layer, or the composition of the microcrystalline glass used for preparing the chemically strengthened microcrystalline glass, or the composition of the base glass, the content of $Li_2O$ can be 25.32%, 25.52%, 25.60%, 25.65%, 25.70%, 25.75%, 25.80%, 25.85%, 25.90%, 25.95%, 26.00%, 26.05%, 26.10%, 26.15%, 26.20%, 26.25%, 26.30%, 26.35%, 26.40%, 26.45%, 25.62%, 25.82%, 25.69%, 25.36%, 25.77%, 25.87%, 25.79%, 26.03%, 25.74%, 26.52%, 25.91% or 25.73%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

Both $Na_2O$ and $Li_2O$ belong to alkali metal oxides, and their common characteristic is that they can destroy the Si-O bonds in the glass, disrupting the glass network and reducing the high-temperature viscosity of the glass. However, excessive addition will significantly damage the weather resistance of the glass. Adding a variety of alkali metal oxides to the glass components will produce a complex "synergistic effect", and the performance of the glass will not change linearly according to the addition of a single alkali metal. This phenomenon, where the properties of glass do not vary linearly with the addition of multiple alkali metal oxides, is called the "mixed alkali effect." For example, regarding the weather resistance of glass, mixing several alkali metal oxides into the glass composition is more beneficial for improving weather resistance than adding a single alkali metal oxide. However, there is still a certain limit, excessive or insufficient amounts make it difficult to achieve the desired effects.

In the present invention, on the basis of adjusting and controlling the content range of each oxide component, by adjusting and controlling the proportion relationship between each oxide component, especially the molar percentage relationship between $Na_2O$, $B_2O_3$, $ZrO_2$ or $Li_2O$, it is beneficial to ensure that the microcrystalline glass with the desired crystalline phase structure can be obtained, and at the same time, it is beneficial to ensure that the microcrystalline glass can obtain excellent optical properties and high intrinsic strength.

In some embodiments of the present invention, in the composition at the center of the chemically strengthened microcrystalline glass or the composition of the tensile stress layer, or the composition of the microcrystalline glass used for preparing the chemically strengthened microcrystalline glass or the composition of the base glass, the mole percentage of $Na_2O$ [$Na_2O$], the mole percentage of $B_2O_3$ [$B_2O_3$] and the mole percentage of $ZrO_2$ [$ZrO_2$] satisfy the following relationship:

$$Z=-1.344\times(2.65-100\times[Na_2O])^2+0.466\times100\times[B_2O_3]+1.203\times100\times[ZrO_2], 4.80\leq Z\leq5.35, \text{ preferably, } 5.05\leq Z\leq5.25.$$

In some embodiments, in the composition at the center of the chemically strengthened microcrystalline glass or the composition of the tensile stress layer, or the composition of the microcrystalline glass used for preparing the chemically strengthened microcrystalline glass, or the composition of the base glass, the value of the molar percentage relationship Formula Z among $Na_2O$, $B_2O_3$ and $ZrO_2$ can be 4.80, 4.85, 4.90, 4.95, 4.98, 5.05, 5.06, 5.07, 5.08, 5.09, 5.10, 5.11, 5.12, 5.13, 5.14, 5.15, 5.16, 5.17, 5.18, 5.19, 5.35, 5.30 or 5.20, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, in the composition at the center of the chemically strengthened microcrystalline glass or the composition of the tensile stress layer, or the composition of the microcrystalline glass used for preparing the chemically strengthened microcrystalline glass, or the composition of the base glass, the mole percentage of $Na_2O$ [$Na_2O$] and the mole percentage of $B_2O_3$ [$B_2O_3$] satisfy the following relationship: $0.90\%\leq[Na_2O]-[B_2O_3]\leq3.10\%$, preferably, $2.00\%\leq[Na_2O]-[B_2O_3]\leq3.00\%$, more preferably, $2.30\%\leq[Na_2O]-[B_2O_3]\leq3.00\%$.

In some embodiments, in the composition at the center of the chemically strengthened microcrystalline glass or the composition of the tensile stress layer, or the composition of the microcrystalline glass used for preparing the chemically strengthened microcrystalline glass, or the composition of the base glass, the difference in mole percentage between $Na_2O$ and $B_2O_3$ [$Na_2O$]-[$B_2O_3$] can be 0.90%, 1.00%, 1.20%, 1.25%, 1.26%, 1.35%, 1.45%, 1.55%, 1.65%, 1.75%, 1.85%, 1.95%, 2.00%, 2.05%, 2.15%, 2.25%, 2.35%, 2.45%, 2.50%, 2.55%, 2.65%, 2.75%, 2.85%, 2.95%, 3.10%, 1.79%, 0.96%, 2.36%, 2.96%, 3.01%, 2.93%, 3.00%, or 3.02%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, in the composition at the center of the chemically strengthened microcrystalline glass or the composition of the tensile stress layer, or the composition of the microcrystalline glass used for preparing the chemically strengthened microcrystalline glass, or the composition of the base glass, the mole percentage of $Na_2O$ [$Na_2O$] and the mole percentage of $Li_2O$ [$Li_2O$] satisfy the following relationship: $8.55 \leq [Li_2O]/[Na_2O] \leq 13.85$, preferably, $8.60 \leq [Li_2O]/[Na_2O] \leq 11.00$.

In some embodiments, in the composition at the center of the chemically strengthened microcrystalline glass or the composition of the tensile stress layer, or the composition of the microcrystalline glass used for preparing the chemically strengthened microcrystalline glass, or the composition of the base glass, the molar percentage ratio [$Li_2O$]/[$Na_2O$] between $Li_2O$ and $Na_2O$ can be 8.55, 9.00, 9.50, 10.00, 10.50, 10.55, 11.00, 11.50, 12.00, 12.50, 13.00, 13.50, 13.83, 10.93, 13.01, 10.92, 8.73, 8.61, 8.79, 8.83, 8.84, 8.69 or 13.85, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, the composition at the center of the chemically strengthened microcrystalline glass or the composition of the tensile stress layer, or the composition of the microcrystalline glass used for preparing the chemically strengthened microcrystalline glass, or the composition of the base glass can further include other components on the basis of the above composition range, as long as the microcrystalline glass or the chemically strengthened microcrystalline glass with the desired properties of the present invention can be obtained. For example, in some embodiments, in terms of oxide molar percentage, the composition at the center of the chemically strengthened microcrystalline glass or the composition of the tensile stress layer, or the composition of the microcrystalline glass used for preparing the chemically strengthened microcrystalline glass, or the composition of the base glass further includes CaO: 0.00mol%-1.00mol%, and $K_2O$: 0.00mol%-1.00mol%.

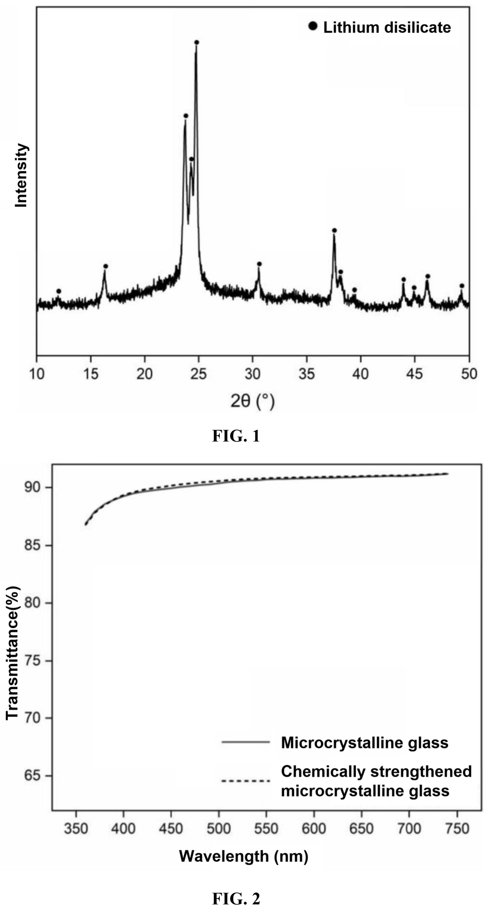

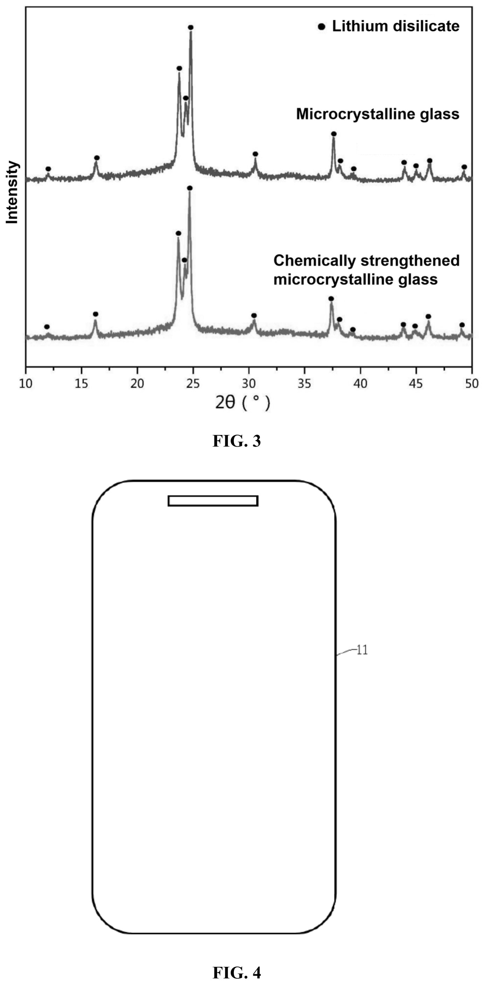

It should be understood that in the present invention, the crystalline phase structure of the microcrystalline glass after chemical strengthening treatment will not change obviously, that is, the crystallinity, average grain size and optical properties of the microcrystalline glass are the same or basically the same as those of the chemically strengthened microcrystalline glass. For example, as can be seen in the comparison of FIG. 2 and FIG. 3. Similarly, it should be understood that the stress structure generated in the chemical strengthening process can appropriately improve the mechanical performance of glass products. In the present invention, after the microcrystalline glass undergoes chemical strengthening to produce chemically strengthened microcrystalline glass, its mechanical properties, such as Young's modulus and Vickers hardness, do not decrease. That is, when the Young's modulus of microcrystalline glass is greater than 100GPa, the Young's modulus of chemically strengthened microcrystalline glass prepared by it will also be greater than 100GPa.

In the present invention, "the lithium disilicate crystalline phase has a larger mass percentage than other crystalline phases existing in the chemically strengthened microcrystalline glass" or "with lithium disilicate as the main crystalline phase" or other similar expressions mean that the lithium disilicate crystalline phase accounts for more than 70 mass percentage of all crystalline phases of the microcrystalline glass or chemically strengthened microcrystalline glass according to the embodiment of the present invention. In some embodiments, the mass of the lithium disilicate crystalline phase accounts for more than 70% of the microcrystalline glass used for preparing the chemically strengthened microcrystalline glass, or the chemically strengthened microcrystalline glass. Preferably, the mass of the lithium disilicate crystalline phase accounts for more than 85% of the microcrystalline glass used for preparing the chemically strengthened microcrystalline glass, or the chemically strengthened microcrystalline glass. Exemplary, in all crystalline phases of the microcrystalline glass used for preparing the chemically strengthened microcrystalline glass, or the chemically strengthened microcrystalline glass, the mass ratio (also referred to as weight ratio) of the lithium disilicate crystalline phase can be 70%, 79%, 80%, 81%, 82%, 83%, 84%, 85%, 86%, 87%, 88%, 89%, 90%, 91%, 92%, 93%, 94%, 96%, 97%, 98%, 100% or 95%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, the crystallinity of microcrystalline glass or chemically strengthened microcrystalline glass is above 45%, preferably, the crystallinity of microcrystalline glass or chemically strengthened microcrystalline glass is 45%-85%, and more preferably, the crystallinity of microcrystalline glass or chemically strengthened microcrystalline glass is 55%-65%. The higher the crystallinity of microcrystalline glass or chemically strengthened microcrystalline glass, the more favorable it is for microcrystalline glass or chemically strengthened microcrystalline glass to obtain high impact resistance and high intrinsic strength. However, excessively high crystallinity not only affects the chemical strengthening efficacy of the microcrystalline glass, resulting in prolonged chemical strengthening time for obtaining chemically strengthened microcrystalline glass with high stress level, but also affects the optical properties of microcrystalline glass. In the present invention, by making the microcrystalline glass meet the expected crystallinity, it is beneficial to ensure that the microcrystalline glass possesses excellent optical properties under the condition of satisfying better impact resistance and high intrinsic strength, and at the same time, it is beneficial to improve its chemical strengthening effect.

In some embodiments of the present invention, the crystallinity of microcrystalline glass or chemically strengthened microcrystalline glass can be 45%, 50%, 55%, 60%, 65%, 70%, 75%, 80% or 85%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, non-limiting examples of other possible crystalline phases in microcrystalline glass or chemically strengthened microcrystalline glass include: lithium phosphate crystalline phase. In some embodiments, preferably, the microcrystalline glass or chemically strengthened microcrystalline glass does not contain the petalite crystalline phase. The term "does not contain the petalite crystalline phase" here includes that the content of the petalite crystalline phase is 0, or the content does not exceed 0.1%. By controlling the precipitation of other crystalline phases, it is more beneficial to ensure that lithium disilicate forms the expected structure, thus ensuring that the microcrystalline glass or chemically strengthened microcrystalline glass obtains high mechanical strength performance, excellent optical properties and excellent damage resistance performance.

In some embodiments of the present invention, in the microcrystalline glass or chemically strengthened microcrystalline glass, the average grain size is below 40nm, and preferably, the average grain size is 15nm-35nm. An appropriate average grain size is beneficial to make microcrystalline glass have excellent optical properties and high intrinsic strength. However, if the average grain size is excessively large, microcrystalline glass will easily become opaque and the chemical strengthening effect will be affected. In the present invention, by making the microcrystalline glass meet the appropriate average grain size, it is beneficial to ensure that the microcrystalline glass possesses excellent optical properties under the condition of satisfying better impact resistance and high intrinsic strength, and at the same time, it is beneficial to improve its chemical strengthening effect.

In some embodiments, the average grain size of the microcrystalline glass or chemically strengthened microcrystalline glass can be 40nm, 35nm, 30nm, 25nm, 20nm, 15nm or 10nm, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, the microcrystalline glass or chemically strengthened microcrystalline glass are transparent in the wavelength range of visible light, and preferably, at a thickness of 0.70mm and for light with a wavelength of 550nm, the transmittance of the microcrystalline glass or chemically strengthened microcrystalline glass is ≥90.00%, preferably, the transmittance is >90.40%. The chemically strengthened microcrystalline glass meeting this transmittance requirement ensures superior light transmission and superior transparency, making it suitable for display screens demanding high display performance. The "visible light wavelength range" herein refers to light with a wavelength of 360nm-740nm.

In some embodiments, at a thickness of 0.70mm, for light with a wavelength of 550nm, the transmittance of microcrystalline glass or chemically strengthened microcrystalline glass can be 90.00%, 90.10%, 90.20%, 90.31%, 90.40%, 90.50%, 91.00%, 90.52%, 90.70%, 90.62%, 90.85%, 90.70%, 90.63%, 90.51% or 92.00%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, the haze of the microcrystalline glass or chemically strengthened microcrystalline glass is <0.30% at a thickness of 0.70 mm. Haze refers to the cloudy or turbid appearance of microcrystalline glass or chemically strengthened microcrystalline glass caused by light scattering at its interior or surfaces. The lower the haze, the better the transparency and display performance of microcrystalline glass or chemically strengthened microcrystalline glass. In some embodiments, at a thickness of 0.70 mm, the haze of the microcrystalline glass or chemically strengthened microcrystalline glass can be 0.25%, 0.20%, 0.15%, 0.10%, 0.05%, 0.21%, 0.14%, 0.13%, 0.15%, 0.16% or 0.29%, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, at a thickness of 0.70mm, the b value of the microcrystalline glass or the chemically strengthened microcrystalline glass is <0.70, preferably, the b value is ≤0.60. In the present invention, the b value refers to the optical b value measured under a D65 light source. In the present invention, the b value is measured in transmittance mode using a Konica Minolta CM-3600A spectrophotometer, and the result shows b (D65). The smaller the b value is, the better the display effect of microcrystalline glass or chemically strengthened microcrystalline glass can be ensured. When the b value is relatively high, undesirable coloration occurs in the microcrystalline glass or chemically strengthened microcrystalline glass, resulting in its display performance not meeting the application requirements of display screen cover glass.

In some embodiments, at a thickness of 0.70mm, the b value of the microcrystalline glass or chemically strengthened microcrystalline glass can be 0.69, 0.65, 0.60, 0.55, 0.50, 0.45, 0.40, 0.35, 0.30, 0.25, 0.48, 0.47, 0.52, 0.51, 0.54 or 0.20, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

The microcrystalline glass or chemically strengthened microcrystalline glass in the present invention exhibit high transmittance, low haze and low b value, collectively demonstrating that the microcrystalline glass or chemically strengthened microcrystalline glass in the present invention have excellent optical properties and good uniformity and in transparent status, thus satisfying the application requirements of the display screen cover glass of electronic device.

In some embodiments of the present invention, the Young's modulus of the microcrystalline glass or chemically strengthened microcrystalline glass is ≥100GPa, preferably, the Young's modulus of the microcrystalline glass or chemically strengthened microcrystalline glass is 105GPa-112.50GPa. In the present invention, by ensuring the Young's modulus of the microcrystalline glass or chemically strengthened microcrystalline glass is not less than 100 GPa, it is beneficial to ensuring the high network structural strength of the microcrystalline glass or the chemically strengthened microcrystalline glass, reducing the stress relaxation effect generated by the chemically strengthened microcrystalline glass in ion exchange, and mitigating the weakening effect of high temperature, long duration, and other factors in ion exchange on deep-layer stresses in composite compressive stresses.

In some embodiments, the Young's modulus of microcrystalline glass or chemically strengthened microcrystalline glass can be 100GPa, 105GPa, 110GPa, 106.32GPa, 111.12GPa, 110.82GPa, 111.32GPa, 111.09GPa, 112.10GPa, 111.51GPa or 112.50GPa, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, the Vickers hardness of the microcrystalline glass or the chemically strengthened microcrystalline glass is ≥650kgf/mm$^2$, preferably, the Vickers hardness of the microcrystalline glass or the chemically strengthened microcrystalline glass is 650kgf/mm$^2$-800kgf/mm$^2$. The Vickers hardness of microcrystalline glass or chemically strengthened microcrystalline glass is within the above range, indicating that microcrystalline glass or chemically strengthened microcrystalline glass processes high hardness and high intrinsic strength, thus ensuring excellent mechanical performance.

In some embodiments of the present invention, the Vickers hardness of microcrystalline glass or chemically strengthened microcrystalline glass can be 650kgf/mm$^2$, 654kgf/mm$^2$, 653kgf/mm$^2$, 658kgf/mm$^2$, 659kgf/mm$^2$ or 660kgf/mm$^2$, or a numerical value within a numerical range formed by taking any two of the aforementioned specific numerical values as endpoints, as long as the microcrystalline glass or the chemically strengthened microcrystalline glass with the desired properties of the present invention can be obtained. It should be understood that in a specific embodiment, any of the above ranges can be combined with any other range, as long as the microcrystalline glass or the chemically strengthened microcrystalline glass with the desired properties of the present invention can be obtained.

In some embodiments of the present invention, the chemically strengthened microcrystalline glass is subjected to high-temperature and high-humidity failure test at a temperature of 85°C and a relative humidity of 85%. The high-temperature and high-humidity failure duration is ≥240h, wherein the high-temperature and high-humidity failure duration is the total duration from the beginning of the high-temperature and high-humidity test of the chemically strengthened microcrystalline glass to the appearance of indelible spots or whitish traces in the chemically strengthened microcrystalline glass.

Those skilled in the art can choose the thickness of microcrystalline glass or chemically strengthened microcrystalline glass according to the requirements. In some embodiments of the present invention, the thickness of the microcrystalline glass or chemically strengthened microcrystalline glass is 0.3mm-2 mm, preferably, 0.45 mm-0.8 mm. Illustratively, the thickness of the microcrystalline glass or chemically strengthened microcrystalline glass can be 0.3mm-1.5mm, 0.3mm-1.00mm or 0.40-0.80mm. In a specific embodiment, any of the above ranges can be combined with any other range, as long as the chemically strengthened microcrystalline glass with the desired properties of the present invention can be obtained.

In some embodiments of the present invention, the microcrystalline glass or chemically strengthened microcrystalline glass is planar or curved.

After introducing the composition, crystalline phase structure and stress structure of chemically strengthened microcrystalline glass in the foregoing sections, the preparation method of chemically strengthened microcrystalline glass is introduced in detail below.

In the present invention, the preparation process of chemically strengthened microcrystalline glass mainly includes the preparation process of microcrystalline glass and the chemical strengthening treatment process, wherein the preparation process of microcrystalline glass mainly includes the preparation process of base glass and the heat treatment process of base glass.

In the present invention, the base glass can be prepared by the molding method in the prior art, and there is no restriction in the present invention. For example, the molding methods for the base glass include but are not limited to floating, overflowing, rolling or casting processes. Exemplarily, the base glass is obtained by mixing the components according to the formula, melt molding, and then cooling and annealing.

Exemplarily, each raw material (industrial conventional raw material) is prepared according to the formula ratio, a clarifying agent is added, and then mixed for a period of time, so as to obtain a raw material mixture with uniform mixing. The raw material mixture is placed in a platinum crucible, heated to 1250°C-1680°C, preferably, with a melting temperature of 1480°C-1680°C, and preferably, the mixture is maintained at this temperature for 3h-12h. Then, the resultant is poured into a forming mold for cooling and molding, preferably, cooled to 750°C-1000°C. Then, the resultant is put into an annealing furnace for annealing treatment, preferably, with an annealing temperature of 400°C-650°C and the annealing duration of 10h-48h. Finally, the resultant is cooled to room temperature with the furnace, so as to obtain the base glass. Those skilled in the art can choose the kind and dosage of clarifying agent according to the requirements without requiring creative work. Further, the clarifying agent includes, but is not limited to, one or more of sodium chloride, tin oxide, antimony oxide or arsenic oxide, and the addition amount of the clarifying agent can be 0wt%-1wt% of the total amount of all raw materials.

In some embodiments of the present invention, the heat treatment process of the base glass can include nucleation treatment and/or crystallization treatment, and preferably, the nucleation treatment and crystallization treatment are adopted. In some embodiments, the crystallization treatment includes a one-step crystallization treatment or a two-step crystallization treatment. In some embodiments, in order to prepare curved microcrystalline glass, two-step crystallization treatment can be adopted. When two-step crystallization treatment is adopted, the second step of crystallization treatment is to put the crystallized glass raw material obtained in the first step of crystallization treatment into a hot bending mold, heating it to the crystallization temperature and carrying out 3D hot bending forming treatment.

In some embodiments of the present invention, in order to obtain the desired physical and chemical properties of the microcrystalline glass, when the heat treatment is performed on the base glass, one-step heat treatment can be performed, or two or more steps of heat treatment can further be performed. If the one-step heat treatment is carried out, it means that the nuclearization treatment (i.e., nucleation treatment) is not carried out alone, and the nuclearization and target crystal growth are carried out at the temperature reached in the one-step heat treatment process. The process can be understood as the crystallization treatment is carried out directly. If two-step heat treatment is carried out, it means that two steps of heat treatment processes are carried out, the nuclearization treatment is carried out firstly, namely nucleation treatment, and then the target crystal growth treatment is carried out, namely the crystallization treatment.

In order to precipitate the desired crystalline phase from the microcrystalline glass and obtain the desired physical and chemical properties, further, the temperature of nucleation treatment can be 530°C-600°C, and the duration of nucleation treatment can be 0-24h, preferably, 2h-8h; the crystallization temperature can be 700°C-750°C, and the crystallization duration can be 0.10h-24h, preferably, 1h-3h. During the heat treatment, preferably, the heating rate is controlled to be 5°C/min-15°C/min, and more preferably, the heating rate is 10°C/min. The temperature of nucleation treatment refers to the temperature at which crystal nuclei can be formed. The temperature of crystallization treatment refers to the temperature at which the target crystal is suitable for controllable growth.

After heat treatment, those skilled in the art can further perform other routine steps to obtain microcrystalline glass samples meeting the required specifications or requirements, for example, shaping treatment, cutting treatment (such as cutting with a multi-wire sawing machine), CNC machining treatment (computer numerical control, i.e., numerical control machine tool), thinning treatment or polishing treatment.

In some embodiments of the present invention, the chemically strengthened microcrystalline glass meeting the expected performance can be prepared by performing the specific chemical strengthening treatment on the aforementioned microcrystalline glass.

In the present invention, chemical strengthening treatment, that is, ion exchange method, is to immerse microcrystalline glass in molten salt bath, so that alkali metal ions with smaller ion radius in microcrystalline glass can be exchanged with alkali metal ions with larger ion radius in molten salt bath, thereby forming a compressive stress layer on the surface of microcrystalline glass, so as to obtain a chemically strengthened microcrystalline glass with better mechanical performance.

In some embodiments of the present invention, the chemical strengthening treatment can adopt a single-step strengthening method or a multi-step strengthening method. The molten salt bath for chemical strengthening treatment is a molten salt bath containing sodium salt and/or potassium salt. Preferably, the molten salt bath for chemical strengthening in the present invention is a mixed molten salt bath containing sodium salt and potassium salt, and preferably, the temperature of the molten salt bath is 380°C-500°C, more preferably, the temperature of the molten salt bath is 380°C-470°C. In some embodiments of the present invention, preferably, the concentration of potassium salt in the salt bath is 0wt%-90wt%, and the concentration of sodium salt is 10wt%-100wt%, and more preferably, a certain amount (e.g., 0wt%-0.5wt%) of lithium salt is added to the salt bath. In some embodiments of the present invention, preferably, the concentration of potassium salt in the salt bath is 20wt%-90wt%, and the concentration of sodium salt is 10wt%-80wt%, and more preferably, 0.1wt%-0.5wt% of lithium salt is added to the salt bath. In some embodiments of the present invention, preferably, the duration of chemical strengthening treatment is 0.1h-6h, and preferably, 0.1h-3h. The sodium salt can be selected from at least one of sodium nitrate, sodium sulfate and sodium carbonate, preferably, sodium nitrate. The potassium salt can be selected from at least one of potassium nitrate, potassium sulfate and potassium carbonate, preferably, potassium nitrate. The lithium salt can be selected from at least one of lithium nitrate, lithium sulfate and lithium carbonate, preferably, lithium nitrate.

The microcrystalline glass or chemically strengthened microcrystalline glass with excellent performance provided by the present invention can be used for electronic device, including but not limited to mobile phones, tablet computers, handheld game console, portable digital devices (such as digital cameras), vehicle-mounted central control, electronic whiteboard glass, smart home, smart wear (such as smart bands, smart watches and smart glasses), it can further be used for vehicles, aerocrafts or aircrafts, and it can further be used for glass components with any required microcrystalline glass. For example, it can be used for display screen, cover glass, touch screen, glass inner screen or inner frame of an electronic device, etc. For example, it can be used for a windshield glass of a vehicle, an aerocraft or an aircraft, such as a front windshield or a side windshield. For example, it can be used for work surfaces, other surfaces, appliance doors, floor tiles, wall panels or storage containers. Other surfaces can include but are not limited to exterior wall surfaces, stair treads, column cladding, or countertop surfaces. Storage containers can include but are not limited to cups, plates, medicine bottles, or beverage bottles.

For example, the microcrystalline glass or chemically strengthened microcrystalline glass with excellent performance provided by the present invention can be used for manufacturing glass components. The glass component herein can be regular or irregular and can be manufactured by those skilled in the art according to requirements.

For example, the microcrystalline glass or chemically strengthened microcrystalline glass with excellent performance provided by the present invention can be used for manufacturing cover glass, wherein the cover glass can be a display screen cover, a rear cover or a camera protection cover of electronic device. For example, the microcrystalline glass or chemically strengthened microcrystalline glass with excellent performance provided by the present invention can be used in electronic device. Referring to FIG. 4, FIG. 5 and FIG. 6, in some embodiments of the present invention, an electronic device is provided, wherein the electronic device can be a mobile phone, a tablet computer, a smart wearable device and other electronic products. The electronic device includes a housing 1 assembled outside the electronic device, and the housing 1 includes a display screen cover 11 assembled at the front side and a rear cover 12 assembled at the rear side. The display screen cover 11 is covered on the display module 4, wherein the display screen cover 11 and/or the rear cover 12 are made of the aforementioned microcrystalline glass or chemically strengthened microcrystalline glass. In the present invention, the display screen cover 11 and the rear cover 12 can all adopt the aforementioned microcrystalline glass or chemically strengthened microcrystalline glass, or only partially adopt the aforementioned microcrystalline glass or chemically strengthened microcrystalline glass. In the present invention, the display screen can be a touch display screen, and the display screen cover 11 can be a protective cover arranged on the touch display screen. In the present invention, the rear cover 12 can cover only the rear side of the electronic device (that is, the side facing away from the display screen), or the rear cover can cover both the rear side and the side frame of the electronic device. Alternatively, the rear cover 12 can cover all the side frames around the electronic device or cover part of the side frame.

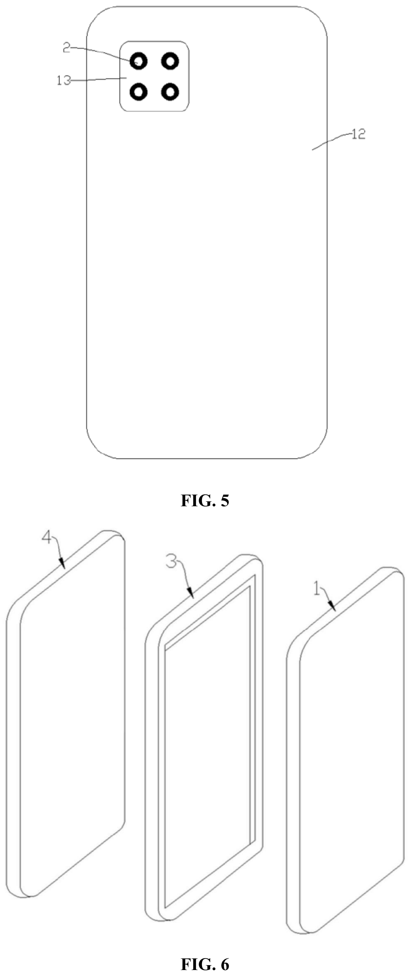

In some embodiments of the present invention, as shown in FIG. 5, the electronic device further includes a camera assembly 2 located inside the housing 1, and the housing 1 can include a camera protection cover 13, wherein the camera protection cover 13 is covered on the camera assembly 2 to protect the camera assembly 2. The camera protection cover 13 is made of the aforementioned microcrystalline glass or chemically strengthened microcrystalline glass. In the present invention, the camera protection cover 13 can be partially made of the aforementioned microcrystalline glass or chemically strengthened microcrystalline glass, or it can be entirely made of the aforementioned microcrystalline glass or chemically strengthened microcrystalline glass. In the present invention, the setting position of the camera protection cover 13 depends on the setting position of the camera assembly 2, it can be located at the front side of the electronic device, or it can further be located at the rear side of the electronic device. In some embodiments of the present invention, the camera protection cover 13 can be a separate structure from the display screen cover 11 or the rear cover 12. In other embodiments of the present invention, the camera protection cover 13 can further be integrated with the display screen cover 11 or the rear cover 12.

In some embodiments of the present invention, as shown in FIG. 6, the electronic device further includes a middle frame 3 located between the display module 4 and the housing 1, wherein the middle frame 3 can include the aforementioned microcrystalline glass or chemically strengthened microcrystalline glass.

In the embodiment of the present invention, for the display screen cover, the rear cover, the camera protection cover and the middle frame in the electronic device, any one of the four components can be made of the aforementioned microcrystalline glass or chemically strengthened microcrystalline glass, or any two of the four components can be made of the aforementioned microcrystalline glass or chemically strengthened microcrystalline glass, or any three of the four components can be made of the aforementioned microcrystalline glass or chemically strengthened microcrystalline glass, or all the four components can be made of the aforementioned microcrystalline glass or chemically strengthened microcrystalline glass.

In the following, the technical solutions of the present invention will be further described in detail with examples. The following detailed description of the examples of the present invention is exemplary, only for explaining the present invention, and cannot be understood as limiting the present invention.

Example 1

(1) Preparation of base glass.

The raw materials (industrial conventional raw materials) were prepared according to the proportion of each component in Table 1, and the total mass of the prepared raw materials was 1000g, and 5g of clarifying agent sodium chloride (NaCl) was added to the prepared raw materials, and then they were mixed with a V-mixer for 30 minutes, so as to obtain a uniformly mixed raw material mixture.

The raw material mixture was transferred to a platinum crucible and then melted at 1650°C for 5 hours. The melt was then poured into a forming mold for cooling and molding with being cooled to 900°C, and subsequently, the resultant was annealed in an annealing furnace at 500°C for 24 hours before being cooled to room temperature with the furnace, so as to obtain the base glass brick.

(2) Preparation of microcrystalline glass: according to the heat treatment process in Table 2, the base glass brick was placed in an annealing furnace and heated from room temperature to 550°C at a rate of 10°C/min for nucleation treatment. After 4h of heat preservation treatment at this temperature, the resultant was then further heated to 710°C at a rate of 10°C/min for crystallization treatment, and after 1.5h of heat preservation treatment at this temperature, the resultant was cooled to room temperature at a rate of 1°C/min, so as to obtain the microcrystalline glass sample brick. The composition of the obtained microcrystalline glass, in terms of the mole percentage of oxides, was identical to that of the base glass, as shown in Table 1.

The microcrystalline glass sample brick was sequentially subjected to cold processing treatment such as cutting, CNC machining (the CNC instrument model used in the present invention was: RCG500S), and polishing, so as to obtain the microcrystalline glass sample meeting the required specifications and requirements. In Examples 1-7 and Comparative Examples 1-6 of the present invention, the microcrystalline glass sample bricks were subjected to the aforementioned cold processing treatment, so as to obtain the microcrystalline glass samples with a thickness of 0.70mm, specifically, the microcrystalline glass polished sheet samples of 50mm×50mm×0.70mm or 157.79mm×73.82mm×0.70mm were made.

Testing of the microcrystalline glass sample obtained in Example 1 was conducted as follows:
the crystalline phase composition, crystallinity, average grain size, Vickers hardness, Young's modulus, and optical b value, haze and transmittance (at 550nm wavelength) of microcrystalline glass samples with a thickness of 0.70mm were tested respectively, and the results are shown in Table 2 respectively.

(3) Preparation of chemically strengthened microcrystalline glass: according to the chemical strengthening process in Table 3, the obtained microcrystalline glass sample was preheated in the strengthening furnace chamber for 5 min, after preheating, the sample was rapidly immersed in a 460°C molten salt bath for chemical strengthening treatment, wherein the composition of molten salt was 90wt% $KNO_3$+10wt% $NaNO_3$+0.15wt% $LiNO_3$, wherein "0.15wt% $LiNO_3$" was added at 0.15wt% of $LiNO_3$ relative to the total mass of $KNO_3$ and $NaNO_3$, and other similar expressions followed the similar meanings. After 3 h of chemical strengthening treatment, the microcrystalline glass sample was taken out and slowly cooled to room temperature on the furnace body of the strengthening furnace, and the salt wrapped on the microcrystalline glass surface was rinsed with clean water. After the microcrystalline glass sample was dried, the chemically strengthened microcrystalline glass can be obtained.

Testing of the chemically strengthened microcrystalline glass from Example 1 was conducted as follows:

I. The chemically strengthened microcrystalline glass was measured for DOL_0, CS_50, and |CT_AV| using an SLP-2000 stress meter (wherein the light source wavelength was 518nm, SOC = 26 (nm/cm)/MPa, refractive index was set to 1.56, exposure time: 300 $\mu$sec). The value of tensile stress line density (CT_LD) was then calculated, with the results shown in Table 3.

II. The mass percentage of $Na_2O$ on the surface of the chemically strengthened microcrystalline glass and the mass percentage of $K_2O$ on the surface of the chemically strengthened microcrystalline glass were determined by XRF, with the results shown in Table 3. Formulas N and Y were then calculated.

III. The average anti-abrasive-paper drop height of chemically strengthened microcrystalline glass was tested, and high-temperature and high-humidity test was performed on the chemically strengthened microcrystalline glass, with the results shown in Table 3.

Example 2-Example 7

Example 2 to Example 7 were respectively carried out with reference to Example 1, with the differences being that the raw material compositions, various process parameters, and corresponding test results for each example are shown in Tables 1-3 respectively.

The XRD pattern of the microcrystalline glass from Example 1 is shown in FIG. 1. As can be seen from the figure, the main crystalline phase in the microcrystalline glass is the lithium disilicate phase.

The comparison diagram of the transmittance curves between the microcrystalline glass and the chemically strengthened microcrystalline glass in Example 1 is shown in FIG. 2. As can be seen from the figure, both the microcrystalline glass and the chemically strengthened microcrystalline glass prepared by the microcrystalline glass are transparent in the visible light range with high transmittance, while essentially maintaining unchanged transmittance before and after chemical strengthening.

The comparison diagram of XRD patterns between the microcrystalline glass and the chemically strengthened microcrystalline glass in Example 1 is shown in FIG. 3. As can be seen from the figure, no significant changes occurred in the crystalline phase structure of the microcrystalline glass before and after chemical strengthening treatment, with the lithium disilicate phase remaining as the main crystalline phase in the chemically strengthened microcrystalline glass prepared from the microcrystalline glass.

Comparative Example 1-Comparative Example 6

Comparative Example 1 to Comparative Example 6 were respectively carried out with reference to Example 1, with the differences being that the raw material compositions, various process parameters, and corresponding test results for each comparative example are shown in Tables 1-3 respectively.

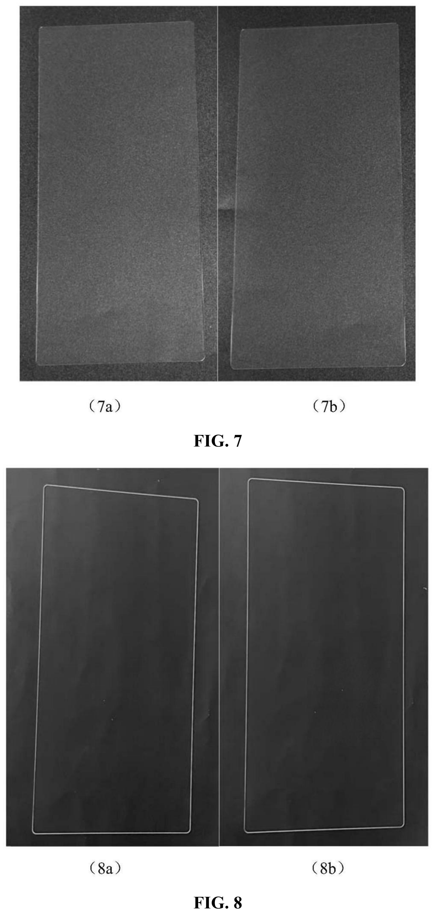

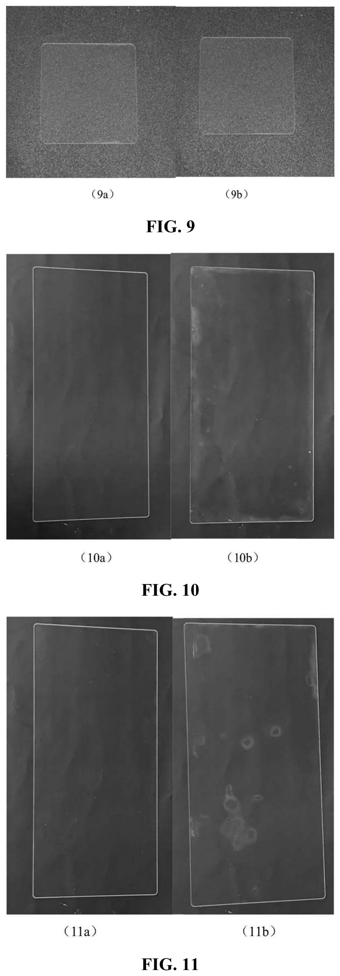

The physical pictures of chemically strengthened microcrystalline glass provided by Examples 1 to 3 and Comparative Examples 1 to 2 before and after the high-temperature and high-humidity test are shown in FIG. 7 to FIG. 11, respectively. In order to show the state of chemically strengthened microcrystalline glass, the pictures were taken on paper with black background. From the comparison of the physical comparison diagrams, it can be seen that, according to the present invention, the chemically strengthened microcrystalline glass achieves superior high-temperature and high-humidity resistance while maintaining high stress levels by satisfying specific relational requirements among the mass percentage of $Na_2O$, the mass percentage of $K_2O$ on the surface of the chemically strengthened microcrystalline glass, as well as the CT_LD, thus indicating its superior weather resistance.

Table 1

| Oxides (mol%) | $SiO_2$ | $Al_2O_3$ | $P_2O_5$ | $ZrO_2$ | $Na_2O$ | $Li_2O$ | Z | $[Na_2O]-[B_2O_3]$ | $[Li_2O]/[Na_2O]$ |
|---|---|---|---|---|---|---|---|---|---|
| Example 1 | 63.26 | 2.87 | 1.41 | 4.33 | 2.36 | 25.77 | 5.10 | 2.36 | 10.92 |
| Example 2 | 63.26 | 2.87 | 1.41 | 4.33 | 2.36 | 25.77 | 5.10 | 2.36 | 10.92 |
| Example 3 | 63.26 | 2.87 | 1.41 | 4.33 | 2.36 | 25.77 | 5.10 | 2.36 | 10.92 |

(continued)

| Oxides (mol%) | SiO$_2$ | Al$_2$O$_3$ | P$_2$O$_5$ | ZrO$_2$ | Na$_2$O | Li$_2$O | Z | [Na$_2$O]-[B$_2$O$_3$] | [Li$_2$O]/[Na$_2$O] |
|---|---|---|---|---|---|---|---|---|---|
| Example 4 | 62.35 | 2.94 | 1.53 | 4.34 | 2.93 | 25.91 | 5.12 | 2.93 | 8.84 |
| Example 5 | 62.35 | 2.94 | 1.53 | 4.34 | 2.93 | 25.91 | 5.12 | 2.93 | 8.84 |
| Example 6 | 62.52 | 2.92 | 1.53 | 4.34 | 2.96 | 25.73 | 5.09 | 2.96 | 8.69 |
| Example 7 | 62.52 | 2.92 | 1.53 | 4.34 | 2.96 | 25.73 | 5.09 | 2.96 | 8.69 |
| Comparative Example 1 | 63.26 | 2.87 | 1.41 | 4.33 | 2.36 | 25.77 | 5.10 | 2.36 | 10.92 |
| Comparative Example 2 | 63.26 | 2.87 | 1.41 | 4.33 | 2.36 | 25.77 | 5.10 | 2.36 | 10.92 |
| Comparative Example 3 | 63.26 | 2.87 | 1.41 | 4.33 | 2.36 | 25.77 | 5.10 | 2.36 | 10.92 |
| Comparative Example 4 | 63.26 | 2.87 | 1.41 | 4.33 | 2.36 | 25.77 | 5.10 | 2.36 | 10.92 |
| Comparative Example 5 | 63.89 | 2.90 | 1.43 | 3.87 | 1.88 | 26.63 | 3.86 | 1.88 | 13.85 |
| Comparative Example 6 | 62.62 | 2.85 | 1.40 | 4.78 | 2.83 | 25.52 | 5.71 | 2.83 | 9.02 |

[0255] Note: the content percentages in Table 1 were input into the formulas as molar percentages of oxides, with the molar units excluded from the actual calculations.

Table 2

| | Nucleation Temp.(°C) | Nucleation Duration (h) | Crystallization Temp. (°C) | Crystallization Time (h) | Main Crystal Phase | Crystallinity | Avg. Crystal Size (nm) | Young's Modulus (GPa) | Vickers Hardness-Pre-strengthening (kgf/mm$^2$) | b value | Transmittance @550nm | Haze | Na$_2$O in microcrystalline glass (wt%) |
|---|---|---|---|---|---|---|---|---|---|---|---|---|---|
| Example 1 | 550 | 4 | 710 | 1.5 | Li$_2$Si$_2$O$_5$ | 59.97% | 28.20 | 111.12 | 654.02 | 0.48 | 90.70% | 0.14% | 3.16% |
| Example 2 | 550 | 4 | 710 | 1.5 | Li$_2$Si$_2$O$_5$ | 59.97% | 28.20 | 111.12 | 654.02 | 0.48 | 90.70% | 0.14% | 3.16% |
| Example 3 | 550 | 4 | 710 | 1.5 | Li$_2$Si$_2$O$_5$ | 59.97% | 28.20 | 111.12 | 654.02 | 0.48 | 90.70% | 0.14% | 3.16% |
| Example 4 | 550 | 4 | 710 | 1.5 | Li$_2$Si$_2$O$_5$ | 59.82% | 29.11 | 111.09 | 653.40 | 0.47 | 90.31% | 0.15% | 3.14% |
| Example 5 | 550 | 4 | 710 | 1.5 | Li$_2$Si$_2$O$_5$ | 59.82% | 29.11 | 111.09 | 653.40 | 0.47 | 90.31% | 0.15% | 3.14% |
| Example 6 | 550 | 4 | 710 | 1.5 | Li$_2$Si$_2$O$_5$ | 59.30% | 29.31 | 111.51 | 658.89 | 0.50 | 90.62% | 0.13% | 3.16% |
| Example 7 | 550 | 4 | 710 | 1.5 | Li$_2$Si$_2$O$_5$ | 59.30% | 29.31 | 111.51 | 658.89 | 0.50 | 90.62% | 0.13% | 3.16% |
| Comparative Example 1 | 550 | 4 | 710 | 1.5 | Li$_2$Si$_2$O$_5$ | 59.97% | 28.20 | 111.12 | 654.02 | 0.48 | 90.70% | 0.14% | 3.16% |
| Comparative Example 2 | 550 | 4 | 710 | 1.5 | Li$_2$Si$_2$O$_5$ | 59.97% | 28.20 | 111.12 | 654.02 | 0.48 | 90.70% | 0.14% | 3.16% |
| Comparative Example 3 | 550 | 4 | 710 | 1.5 | Li$_2$Si$_2$O$_5$ | 59.97% | 28.20 | 111.12 | 654.02 | 0.48 | 90.70% | 0.14% | 3.16% |
| Comparative Example 4 | 550 | 4 | 710 | 1.5 | Li$_2$Si$_2$O$_5$ | 59.97% | 28.20 | 111.12 | 654.02 | 0.48 | 90.70% | 0.14% | 3.16% |
| Comparative Example 5 | 550 | 4 | 710 | 1.5 | Li$_2$Si$_2$O$_5$ | 60.92% | 34.40 | 114.59 | 653.21 | 1.41 | 89.73% | 0.48% | 2.45% |
| Comparative Example 6 | 550 | 4 | 710 | 1.5 | Li$_2$Si$_2$O$_5$ | 59.06% | 52.40 | 117.09 | 658.29 | 2.81 | 87.93% | 1.13% | 3.41% |

Table 3

| | Strengthening Temp.(°C) | Strengthening Duration (h) | Strengthening Salt Bath | CS_50 (MPa) | \|CT_AV\| (MPa) | DOL-0 (μm) | CT-LD (MPa/mm) | $Na_2O$ on the surface of chemically strengthened microcrystalline glass (wt%) | $K_2O$ on the surface of chemically strengthened microcrystalline glass (wt%) | Y | N | Average anti-abrasive paper drop height(m) | Result of high-temperature and high-humidity test |
|---|---|---|---|---|---|---|---|---|---|---|---|---|---|
| Example 1 | 460 | 3.00 | $90wt\%KNO_3+10wt\%NaNO_3+0.15wt\%LiNO_3$ | 162.81 | 78.26 | 137.49 | 47517.24 | 5.30% | 1.250% | 13.25 | -4.47 | 1.57 | Qualified |
| Example 2 | 460 | 3.00 | $80wt\%KNO_3+20wt\%NaNO_3+0.15wt\%LiNO_3$ | 166.33 | 79.83 | 138.74 | 48185.39 | 6.12% | 0.809% | 10.14 | -10.59 | 1.59 | Qualified |
| Example 3 | 460 | 3.00 | $70wt\%KNO_3+30wt\%NaNO_3+0.15wt\%LiNO_3$ | 170.25 | 84.20 | 143.44 | 49692.43 | 7.00% | 0.774% | 0.36 | -2.52 | 1.65 | Qualified |
| Example 4 | 460 | 3.00 | $90wt\%KNO_3+10wt\%NaNO_3+0.15wt\%LiNO_3$ | 165.17 | 79.01 | 138.98 | 47636.26 | 5.21% | 1.237% | 14.84 | -4.75 | 1.58 | Qualified |
| Example 5 | 460 | 3.00 | $80wt\%KNO_3+20wt\%NaNO_3+0.15wt\%LiNO_3$ | 169.43 | 80.77 | 142.35 | 47919.69 | 6.32% | 0.797% | 13.02 | -12.73 | 1.62 | Qualified |
| Example 6 | 460 | 3.00 | $90wt\%KNO_3+10wt\%NaNO_3+0.15wt\%LiNO_3$ | 167.89 | 77.61 | 134.98 | 47679.19 | 5.17% | 1.263% | 11.88 | -4.07 | 1.59 | Qualified |
| Example 7 | 460 | 3.00 | $80wt\%KNO_3+20wt\%NaNO_3+0.15wt\%LiNO_3$ | 170.28 | 79.23 | 137.53 | 48097.14 | 6.36% | 0.804% | 11.58 | -11.90 | 1.61 | Qualified |
| Comparative Example 1 | 460 | 2.50 | $50wt\%KNO_3+50wt\%NaNO_3+0.15wt\%LiNO_3$ | 176.12 | 86.07 | 144.08 | 50638.67 | 9.35% | 0.409% | 0.91 | 20.08 | 1.70 | Unqualified |
| Comparative Example 2 | 460 | 2.00 | $30wt\%KNO_3+70wt\%NaNO_3+0.15wt\%LiNO_3$ | 166.77 | 85.57 | 143.15 | 50571.87 | 10.13% | 0.212% | 3.29 | 156.90 | 1.68 | Unqualified |

(continued)

| | Strengthening Temp.(°C) | Strengthening Duration (h) | Strengthening Salt Bath | CS_50 (MPa) | \|CT_AV\| (MPa) | DOL-0 ($\mu$m) | CT-LD (MPa/mm) | $Na_2O$ on the surface of chemically strengthened microcrystalline glass (wt%) | $K_2O$ on the surface of chemically strengthened microcrystalline glass (wt%) | Y | N | Average anti-abrasive paper drop height(m) | Result of high-temperature and high-humidity test |
|---|---|---|---|---|---|---|---|---|---|---|---|---|---|
| Comparative Example 3 | 460 | 2.00 | 40wt%$KNO_3$+60wt%$NaNO_3$+0.15wt%$LiNO_3$ | 169.13 | 86.12 | 143.65 | 50773.89 | 9.62% | 0.302% | 1.83 | 54.04 | 1.68 | Unqualified |
| Comparative Example 4 | 460 | 1.50 | 20wt%$KNO_3$+80wt%$NaNO_3$+0.15wt%$LiNO_3$ | 175.28 | 87.18 | 145.48 | 50943.01 | 10.51% | 0.154% | 5.09 | 387.53 | 1.69 | Unqualified |
| Comparative Example 5 | 460 | 3.00 | 70wt%$KNO_3$+30wt%$NaNO_3$+0.50wt%$LiNO_3$ | 119.01 | 61.39 | 148.02 | 35427.29 | 4.69% | 0.405% | 476.33 | -195.55 | 1.26 | Qualified |
| Comparative Example 6 | 460 | 3.00 | 70wt%$KNO_3$+30wt%$NaNO_3$+0.50wt%$LiNO_3$ | 128.52 | 74.08 | 147.42 | 42877.50 | 6.08% | 0.670% | 135.91 | -58.75 | 1.41 | Qualified |

According to the examples and comparative examples in Table 1-Table 3 above, for the same microcrystalline glass, by making the chemically strengthened microcrystalline glass obtained by chemical strengthening meet the requirements of the relationship N in the present invention, that is, by making the mass percentage of $Na_2O$ on the surface of the chemically strengthened microcrystalline glass, the mass percentage of $K_2O$ on the surface of the chemically strengthened microcrystalline glass, as well as CT_LD meet a specific relationship, the chemically strengthened microcrystalline glass can be ensured to process both excellent stress level and excellent high-temperature and high-humidity resistance, thus making the obtained chemically strengthened microcrystalline glass process superior mechanical strength performance and good weather resistance.

However, in the solutions of Comparative Example 1 to Comparative Example 6, the mass percentage of $Na_2O$ on the surface of the chemically strengthened microcrystalline glass, the mass percentage of $K_2O$ on the surface of the chemically strengthened microcrystalline glass, as well as CT_LD, do not satisfy the specified relationship. Ultimately, the chemically strengthened microcrystalline glass produced either exhibited spots or whitish traces that could not be wiped off during high-temperature and high-humidity test, with weather resistance obviously failing to meet application requirements, or had low stress levels, with poor drop damage resistance.

The above are only the detailed examples of the present invention and are not intended to limit the present invention, and for those skilled in the art, the present invention may have various modifications and changes. Any modifications, equivalent substitutions and improvements made within the spirit and principles of the present invention shall be included in the protection scope of the present invention.

**Industrial applicability**

According to the present invention, by making the surface composition and stress structure of chemically strengthened microcrystalline glass with lithium disilicate as the main crystalline phase meet specific requirements, the chemically strengthened microcrystalline glass can achieve good weather resistance while maintaining a high stress level, thereby better ensuring that the chemically strengthened microcrystalline glass meets market application demands.

**Claims**

1. A chemically strengthened microcrystalline glass, **characterized in that** the chemically strengthened microcrystalline glass contains a lithium disilicate crystalline phase and the lithium disilicate crystalline phase has a larger mass percentage than other crystalline phases existing in the chemically strengthened microcrystalline glass; the chemically strengthened microcrystalline glass has a compression stress layer on a surface and tensile stress layer inside; and the chemically strengthened microcrystalline glass satisfies:

   $N = n*(CT\_LD - 50000)/10000$, $-32.5 < N < 15$, preferably, $-28.0 \leq N \leq 0$, and more preferably, $-20.0 \leq N \leq -2.5$, wherein $n = $ (a mass percentage of $Na_2O$ on the surface of the chemically strengthened microcrystalline glass / a mass percentage of $K_2O$ on the surface of the chemically strengthened microcrystalline glass)$^2$; the mass percentage of $Na_2O$ on the surface of the chemically strengthened microcrystalline glass and the mass percentage of $K_2O$ on the surface of the chemically strengthened microcrystalline glass are determined by XRF; CT_LD represents a tensile stress line density, wherein a unit is MPa/mm; in the Formula N, data is substituted for calculation according to above requirements of units, and a calculated result is obtained without comprising the units themselves in the calculation.

2. The chemically strengthened microcrystalline glass according to claim 1, wherein the chemically strengthened microcrystalline glass satisfies: $45000 \text{MPa/mm} \leq CT\_LD \leq 52000 \text{MPa/mm}$, preferably, $45900 \text{MPa/mm} \leq CT\_LD \leq 50000 \text{MPa/mm}$, and more preferably, $47500 \text{MPa/mm} \leq CT\_LD \leq 50000 \text{MPa/mm}$.

3. The chemically strengthened microcrystalline glass according to claim 1 or 2, wherein a value of the Formula N is -2.52, -4.07, -4.47, -4.75, -10.59, -11.90 or -12.73; and/or, a value of CT_LD is 47517.24 MPa/mm, 48185.39 MPa/mm, 49692.43 MPa/mm, 47636.26 MPa/mm, 47919.69 MPa/mm, 47679.19 MPa/mm, or 48097.14 MPa/mm.

4. The chemically strengthened microcrystalline glass according to any one of claims 1-3, wherein as measured by XRF and calculated in terms of an oxide mass percentage, the mass percentage of $Na_2O$ on the surface of the chemically strengthened microcrystalline glass is 5%-8.5%, preferably, 5.5%-7.5%; and/or,

   as measured by XRF and calculated in terms of an oxide mass percentage, the mass percentage of $K_2O$ on the

surface of the chemically strengthened microcrystalline glass is 0.7%-2.0%, preferably, 0.7%-1.5%; and/or, in terms of an oxide mass percentage, in a composition at a center of the chemically strengthened microcrystalline glass or a composition of a tensile stress layer, the mass percentage of $Na_2O$ is 3%-3.5%, preferably, the mass percentage of $Na_2O$ is 3.1%-3.2%.

5. The chemically strengthened microcrystalline glass according to any one of claims 1-4, wherein as measured by XRF and calculated in terms of an oxide mass percentage, the mass percentage of $Na_2O$ on the surface of the chemically strengthened microcrystalline glass is 5.30%, 6.12%, 7.00%, 5.21%, 6.32%, 5.17% or 6.36%; and/or,

   as measured by XRF and calculated in terms of an oxide mass percentage, the mass percentage of $K_2O$ on the surface of the chemically strengthened microcrystalline glass is 1.25%, 0.81%, 0.77%, 1.24%, 0.80% or 1.26%; and/or,
   in terms of an oxide mass percentage, in a composition at a center of the chemically strengthened microcrystalline glass or a composition of a tensile stress layer, the mass percentage of $Na_2O$ is 3.16% or 3.14%.

6. The chemically strengthened microcrystalline glass according to any one of claims 1-5, wherein the chemically strengthened microcrystalline glass satisfies:

   $Y=\Delta C\times((CT\_LD-50000)/100)^2$, $Y<60$, preferably, $Y\leq50$, and more preferably, $Y\leq20$, wherein
   $\Delta C$ represents a difference between the mass percentage of $Na_2O$ on the surface of the chemically strengthened microcrystalline glass and a mass percentage of $Na_2O$ at a center of the chemically strengthened microcrystalline glass, with the mass percentage of $Na_2O$ on the surface of the chemically strengthened microcrystalline glass being measured by XRF; CT_LD represents the tensile stress line density, and the unit is MPa/mm; in the Formula Y, data is substituted for calculation according to the above requirements of units, and a calculated result is obtained without comprising the units themselves in the calculation.

7. The chemically strengthened microcrystalline glass according to any one of claims 1-6, wherein a value of the Formula Y is 0.36, 10.14, 11.58, 11.88, 13.02, 13.25 or 14.84.

8. The chemically strengthened microcrystalline glass according to any one of claims 1-7, wherein the chemically strengthened microcrystalline glass satisfies:

   $75MPa\leq|CT\_AV|\leq120MPa$, preferably, $77MPa\leq|CT\_AV|\leq90MPa$, wherein $|CT\_AV|$ represents an absolute value of an average tensile stress; and/or,
   DOL_0 is 0.18t-0.25t, preferably, 0.20t-0.25t, wherein DOL_0 represents a depth of the compression stress layer and t represents a thickness of the chemically strengthened microcrystalline glass; and/or
   CS_50 is 150MPa-250MPa, preferably, 160 MPa-180 MPa, wherein CS_50 refers to a compressive stress value at a depth of 50µm from a main surface of the chemically strengthened microcrystalline glass.

9. The chemically strengthened microcrystalline glass according to any one of claims 1-8, wherein in terms of an oxide molar percentage, a composition at a center of the chemically strengthened microcrystalline glass or a composition of the tensile stress layer comprises: $SiO_2$: 61.50%-63.40%, $Al_2O_3$: 2.75%-2.99%, $P_2O_5$: 0.91%-1.91%, $ZrO_2$: 4.20%-4.85%, $Na_2O$: 1.80%-3.20%, $B_2O_3$: 0-1.00%, and $Li_2O$: 25.32%-26.52%.

10. The chemically strengthened microcrystalline glass according to any one of claims 1-9, wherein in terms of an oxide molar percentage, a composition at a center of the chemically strengthened microcrystalline glass or a composition of the tensile stress layer comprises:

    a mole percentage of $SiO_2$ is 61.50%-63.30%, preferably, the mole percentage of $SiO_2$ is 62.00%-62.60%; and/or,
    a mole percentage of $P_2O_5$ is 1.20%-1.91%, preferably, the mole percentage of $P_2O_5$ is 1.30%-1.60%; and/or,
    a mole percentage of $Na_2O$ is 1.85%-3.05%, preferably, the mole percentage of $Na_2O$ is 2.20%-3.00%; and/or,
    a mole percentage of $B_2O_3$ is 0-0.65%; and/or, the mole percentage of $ZrO_2$ is 4.20%-4.60%; and/or,
    a mole percentage of $Li_2O$ is 25.52%-26.52%, preferably, the mole percentage of $Li_2O$ is 25.52%-26.00%.

11. The chemically strengthened microcrystalline glass according to any one of claims 1-10, wherein in terms of an oxide molar percentage, a composition at a center of the chemically strengthened microcrystalline glass or a composition of the tensile stress layer comprises:

a mole percentage of $SiO_2$ is 63.26%, 62.35% or 62.52%; and/or,
a mole percentage of $Al_2O_3$ is 2.87%, 2.94% or 2.92%; and/or,
a mole percentage of $P_2O_5$ is 1.41% or 1.53%; and/or,
a mole percentage of $ZrO_2$ is 4.33% or 4.34%; and/or,
a mole percentage of $Na_2O$ is 2.36%, 2.93% or 2.96%; and/or,
a mole percentage of $Li_2O$ is 25.77%, 25.91% or 25.73%.

12. The chemically strengthened microcrystalline glass according to any one of claims 1-11, wherein in a composition at a center of the chemically strengthened microcrystalline glass or a composition of the tensile stress layer, a mole percentage of $Na_2O$ $[Na_2O]$, a mole percentage of $B_2O_3$ $[B_2O_3]$ and a mole percentage of $ZrO_2$ $[ZrO_2]$ satisfy a following relationship:

$Z=-1.344\times(2.65-100\times[Na_2O])^2+0.466\times100\times[B_2O_3]+1.203\times100\times[ZrO_2]$, $4.80\leq Z\leq5.35$, preferably, $5.05\leq Z\leq 5.25$; and/or

in the composition at the center of the chemically strengthened microcrystalline glass or the composition of the tensile stress layer, the mole percentage of $Na_2O$ $[Na_2O]$ and the mole percentage of $B_2O_3$ $[B_2O_3]$ satisfy a following relationship:

$0.90\%\leq[Na_2O]-[B_2O_3]\leq3.10\%$, preferably, $2.00\%\leq[Na_2O]-[B_2O_3]\leq3.00\%$, more preferably, $2.30\%\leq[Na_2O]-[B_2O_3]\leq3.00\%$; and/or
in the composition at the center of the chemically strengthened microcrystalline glass or the composition of the tensile stress layer, the mole percentage of $Na_2O$ $[Na_2O]$ and a mole percentage of $Li_2O$ $[Li_2O]$ satisfy a following relationship:
$8.55\leq[Li_2O]/[Na_2O]\leq13.85$, preferably, $8.60\leq[Li_2O]/[Na_2O]\leq11.00$.

13. The chemically strengthened microcrystalline glass according to claim 12, wherein the composition at the center of the chemically strengthened microcrystalline glass or the composition of the tensile stress layer satisfies:

a value of the Formula Z is 5.10, 5.09 or 5.12; and/or,
a value of $[Na_2O]-[B_2O_3]$ is 2.36%, 2.93% or 2.96%; and/or,
a value of $[Li_2O]/[Na_2O]$ is 10.92, 8.84 or 8.69.

14. The chemically strengthened microcrystalline glass according to any one of claims 1-13, wherein a mass of the lithium disilicate crystalline phase accounts for more than 70% of all crystalline phases of the chemically strengthened microcrystalline glass,
preferably, the mass of the lithium disilicate crystalline phase accounts for more than 85% of all crystalline phases of the chemically strengthened microcrystalline glass.

15. The chemically strengthened microcrystalline glass according to any one of claims 1-14, wherein an average grain size of the chemically strengthened microcrystalline glass is below 40nm, preferably, the average grain size is 15nm-35nm; and/or,
a crystallinity of the chemically strengthened microcrystalline glass is above 45%; preferably, the crystallinity of the chemically strengthened microcrystalline glass is 45%-85%, and more preferably, the crystallinity of the chemically strengthened microcrystalline glass is 55%-65%.

16. The chemically strengthened microcrystalline glass according to any one of claims 1-15, wherein the chemically strengthened microcrystalline glass is transparent in a wavelength range of a visible light, preferably, at a thickness of 0.70mm and for a light with a wavelength of 550nm, a transmittance of the chemically strengthened microcrystalline glass is $\geq90.00\%$, preferably, the transmittance is>90.40%; and/or,

at the thickness of 0.70mm, a haze of the chemically strengthened microcrystalline glass is <0.30%, preferably, the haze is <0.20%; and/or,
at the thickness of 0.70mm, a b value of the chemically strengthened microcrystalline glass is <0.70, preferably, the b value is $\leq0.60$.

17. The chemically strengthened microcrystalline glass according to any one of claims 1-16, wherein a Young's modulus of the chemically strengthened microcrystalline glass is $\geq100GPa$, preferably, the Young's modulus of the chemically strengthened microcrystalline glass is 105GPa-112.50GPa; and/or

a Vickers hardness of the chemically strengthened microcrystalline glass is ≥650kgf/mm$^2$, and preferably, the Vickers hardness of the chemically strengthened microcrystalline glass is 650kgf/mm$^2$-800kgf/mm$^2$.

18. The chemically strengthened microcrystalline glass according to any one of claims 1-17, wherein the chemically strengthened microcrystalline glass is planar or curved; and/or, a thickness of the chemically strengthened microcrystalline glass is 0.3mm-2mm, preferably, 0.45 mm-0.8 mm; and/or, the chemically strengthened microcrystalline glass does not contain a petalite crystalline phase.

19. The chemically strengthened microcrystalline glass according to any one of claims 1-18, wherein the chemically strengthened microcrystalline glass is subjected to a high-temperature and high-humidity failure test at a temperature of 85°C and a relative humidity of 85%; a high-temperature and high-humidity failure duration of the chemically strengthened microcrystalline glass is ≥240h, wherein the high-temperature and high-humidity failure duration is a total duration from a beginning of the high-temperature and high-humidity failure test of the chemically strengthened microcrystalline glass to an appearance of an indelible spot or a whitish trace in the chemically strengthened microcrystalline glass.

20. A cover glass, **characterized in that** the cover glass is made of the chemically strengthened microcrystalline glass according to any one of claims 1-19, or the cover glass comprises the chemically strengthened microcrystalline glass according to any one of claims 1-19.

21. An electronic device, **characterized in that** the electronic device comprises the chemically strengthened microcrystalline glass according to any one of claims 1-19.

22. The electronic device according to claim 21, wherein the electronic device comprises a housing assembled outside the electronic device, and the housing comprises the chemically strengthened microcrystalline glass according to any one of claims 1-19.

23. The electronic device according to claim 22, wherein the housing comprises a display screen cover assembled on a front side of the electronic device, and the display screen cover comprises the chemically strengthened microcrystalline glass according to any one of claims 1-19.

24. The electronic device according to claim 22 or 23, wherein the housing comprises a rear cover assembled on a rear side of the electronic device, and the rear cover comprises the chemically strengthened microcrystalline glass according to any one of claims 1-19.

25. The electronic device according to any one of claims 22-24, wherein the electronic device further comprises a camera assembly located inside the housing, and the housing comprises a camera protection cover, the camera protection cover is mounted over the camera assembly; the camera protection cover comprises the chemically strengthened microcrystalline glass according to any one of claims 1-19.

26. The electronic device according to any one of claims 22-25, wherein the electronic device further comprises a middle frame, and the middle frame comprises the chemically strengthened microcrystalline glass according to any one of claims 1-19.

27. A glass component, **characterized in that** the glass component comprises the chemically strengthened microcrystalline glass according to any one of claims 1-19.

**FIG. 1**

**FIG. 2**

**FIG. 3**

**FIG. 4**

**FIG. 5**

**FIG. 6**

（7a） （7b）

**FIG. 7**

（8a） （8b）

**FIG. 8**

（9a）　　　　　　　　（9b）

**FIG. 9**

（10a）　　　　　　　　（10b）

**FIG. 10**

（11a）　　　　　　　　（11b）

**FIG. 11**

## INTERNATIONAL SEARCH REPORT

| International application No. |
|---|
| **PCT/CN2025/094618** |

**A. CLASSIFICATION OF SUBJECT MATTER**

C03C10/04(2006.01)i; G03B17/56(2021.01)i; G03B11/04(2021.01)i; H05K5/02(2006.01)i; H05K5/03(2006.01)i; G09F9/30(2006.01)i; C03C10/12(2006.01)i; C03C21/00(2006.01)i

According to International Patent Classification (IPC) or to both national classification and IPC

**B. FIELDS SEARCHED**

Minimum documentation searched (classification system followed by classification symbols)

IPC:C03C,G03B,H05K,G09F

Documentation searched other than minimum documentation to the extent that such documents are included in the fields searched

Electronic data base consulted during the international search (name of data base and, where practicable, search terms used)

CNTXT, ENTXT, VEN, CNABS, CNKI, ISI: 微晶, 玻璃, 陶瓷, 化学, 强化, 钢化, 增制, 离子交换, 二硅酸锂, 表面, 压缩应力层, 张应力线密度, Li2Si2O5, Li2O·2SiO2, MPa/mm, microcrystalline, glass, ceramic, chemical, enhance, strengthen, enforcement, temper, ion exchange, lithium disilicate, surface, compressive stress layer, tensile stress line density

**C. DOCUMENTS CONSIDERED TO BE RELEVANT**

| Category* | Citation of document, with indication, where appropriate, of the relevant passages | Relevant to claim No. |
|---|---|---|
| PX | CN 118702411 A (CHONGQING XINJING SPECIAL GLASS CO., LTD.) 27 September 2024 (2024-09-27) claims 1-27 | 1-27 |
| A | CN 117466535 A (CHONGQING XINJING SPECIAL GLASS CO., LTD. et al.) 30 January 2024 (2024-01-30) description, paragraphs 0002, 0007-0053, and 0152 | 1-27 |
| A | CN 111635138 A (CHONGQING LIANGJIANG NEW DISTRICT XIAMEIXI SCIENCE AND TECHNOLOGY PARTNERSHIP ENTERPRISE (LIMITED PARTNERSHIP)) 08 September 2020 (2020-09-08) entire document | 1-27 |
| A | CN 110845153 A (SHENZHEN DONGLIHUA TECHNOLOGY CO., LTD.) 28 February 2020 (2020-02-28) entire document | 1-27 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **12 June 2025** | **14 June 2025** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2025/094618** |

### C. DOCUMENTS CONSIDERED TO BE RELEVANT

| Category* | Citation of document, with indication, where appropriate, of the relevant passages | Relevant to claim No. |
| --- | --- | --- |
| A | CN 112608033 A (CHONGQING XINJING SPECIAL GLASS CO., LTD.) 06 April 2021 (2021-04-06)<br>    entire document | 1-27 |
| A | CN 112441746 A (CHONGQING XINJING SPECIAL GLASS CO., LTD.) 05 March 2021 (2021-03-05)<br>    entire document | 1-27 |
| A | CN 112919812 A (HUAWEI TECHNOLOGIES CO., LTD. et al.) 08 June 2021 (2021-06-08)<br>    entire document | 1-27 |
| A | CN 113387586 A (CDGM GLASS CO., LTD.) 14 September 2021 (2021-09-14)<br>    entire document | 1-27 |
| A | CN 117466534 A (CHONGQING XINJING SPECIAL GLASS CO., LTD. et al.) 30 January 2024 (2024-01-30)<br>    entire document | 1-27 |
| A | CN 117776535 A (CHONGQING XINJING SPECIAL GLASS CO., LTD.) 29 March 2024 (2024-03-29)<br>    entire document | 1-27 |
| A | US 2020148591 A1 (CORNING INC.) 14 May 2020 (2020-05-14)<br>    entire document | 1-27 |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| CN | 118702411 | A | 27 September 2024 | None | | | |
| CN | 117466535 | A | 30 January 2024 | None | | | |
| CN | 111635138 | A | 08 September 2020 | None | | | |
| CN | 110845153 | A | 28 February 2020 | None | | | |
| CN | 112608033 | A | 06 April 2021 | None | | | |
| CN | 112441746 | A | 05 March 2021 | None | | | |
| CN | 112919812 | A | 08 June 2021 | None | | | |
| CN | 113387586 | A | 14 September 2021 | None | | | |
| CN | 117466534 | A | 30 January 2024 | None | | | |
| CN | 117776535 | A | 29 March 2024 | None | | | |
| US | 2020148591 | A1 | 14 May 2020 | TW | 202026267 | A | 16 July 2020 |
| | | | | TWI | 725615 | B | 21 April 2021 |
| | | | | JP | 2022511158 | A | 31 January 2022 |
| | | | | JP | 7269252 | B2 | 08 May 2023 |
| | | | | EP | 3752470 | A2 | 23 December 2020 |
| | | | | EP | 3752470 | B1 | 30 August 2023 |
| | | | | US | 2021387905 | A1 | 16 December 2021 |
| | | | | US | 11634360 | B2 | 25 April 2023 |
| | | | | TW | 202208303 | A | 01 March 2022 |
| | | | | TWI | 781787 | B | 21 October 2022 |
| | | | | US | 2023242442 | A1 | 03 August 2023 |
| | | | | TW | 202134198 | A | 16 September 2021 |
| | | | | TWI | 746395 | B | 11 November 2021 |
| | | | | KR | 20200139691 | A | 14 December 2020 |
| | | | | KR | 102511592 | B1 | 17 March 2023 |
| | | | | US | 11104608 | B2 | 31 August 2021 |
| | | | | WO | 2020102231 | A2 | 22 May 2020 |
| | | | | WO | 2020102231 | A3 | 30 July 2020 |
| | | | | KR | 20230041088 | A | 23 March 2023 |
| | | | | JP | 2023100724 | A | 19 July 2023 |

**REFERENCES CITED IN THE DESCRIPTION**

**Patent documents cited in the description**

- CN 202410590891

**Non-patent literature cited in the description**

- **ROBERT L. SMITH** ; **GEORGE E. SANDLAND**. In the present invention, Vickers hardness refers to a standard for indicating the hardness of materials proposed. *Vickers Ltd.*, 1921